# EUROPÄISCHE PATENTANMELDUNG

(11) **EP 4 614 555 A2**
(43) Veröffentlichungstag der Anmeldung: **10.09.2025**
(21) Anmeldenummer: 25191602.9
(22) Anmeldetag: 15.10.2024
(51) Int. Cl.: H01L 21/67

(54) **VERFAHREN ZUR HERSTELLUNG EINES III-V-SUBSTRATS, INSBESONDERE GAAS UND INP**

(30) Priorität: 16.10.2023 DE 102023210126
(62) Teilanmeldung aus: 24790918.7
(71) Anmelder: Freiberger Compound Materials GmbH, 09599 Freiberg (DE)
(72) Erfinder: FLIEGEL, Wolfram, 01187 Dresden (DE); SCHEFFER-CZYGAN, Max, 09116 Chemnitz (DE); DEUTSCH, Denny, 01705 Freital (DE); WEINERT, Berndt, 09599 Freiberg (DE); DIETRICH, Marc, 09603 Großschirma (DE); EICHLER, Stefan, 01187 Dresden (DE)
(74) Vertreter: Prüfer & Partner mbB Patentanwälte · Rechtsanwälte

(57) **Zusammenfassung**

Die vorliegende Erfindung umfasst eine Vorrichtung zum Trocknen von Wafern, welche umfassend:
ein Bad (1) mit Flüssigkeit;
einen Keil (2),
mindestens eine Lagervorrichtung (5), welche vertikal verfahrbar ist;
wobei mindestens eine Horde (3; 31, 32) in die Lagervorrichtung (5) einsetzbar ist,
wobei die mindestens eine Horde (3; 31, 32) umfasst:
ein Paar von ersten seitlichen Führungsvorrichtungen (3a, 3a'), ein Paar von zweiten seitlichen Führungsvorrichtungen (3b, 3b') sowie ein Paar von dritten seitlichen Führungsvorrichtungen (3c, 3c'),
wobei das Paar von ersten seitlichen Führungsvorrichtungen (3a, 3a') unterhalb des Paars von zweiten seitlichen Führungsvorrichtungen (3b, 3b') angeordnet ist, und das Paar von zweiten seitlichen Führungsvorrichtungen (3b, 3b') unterhalb des Paars von dritten seitlichen Führungsvorrichtungen (3c, 3c') angeordnet ist, und wobei der Abstand des Paars von ersten seitlichen Führungsvorrichtungen (3a, 3a') voneinander kleiner ist als der Abstand des Paars von zweiten seitlichen Führungsvorrichtungen (3b, 3b') voneinander, und der Abstand des Paars von zweiten seitlichen Führungsvorrichtungen (3b, 3b') voneinander kleiner ist als der Abstand des Paars von dritten seitlichen Führungsvorrichtungen (3c, 3c') voneinander,
wobei der Keil (2) unterhalb der Horde (3) vorgesehen ist und vertikal getrennt von der Lagervorrichtung (5) verfahrbar ist, wobei der Keil (2) mindestens zwei Keilabschnitte (2a, 2b) umfasst, wobei beide Keilabschnitte (2a,2b) getrennt voneinander vertikal verfahrbar sind, wobei in die Lagervorrichtung (5) mindestens eine erste Horde (31) so einsetzbar ist, dass die Mitte der mindestens ersten Horde (31) oberhalb der Spitze des ersten Keilabschnitts (2a) positioniert ist, und ferner eine zweite Horde (32) so einsetzbar ist, dass die Mitte der zweiten Horde (32) oberhalb der Spitze des zweiten Keilabschnitts (2b) positioniert ist.

So eine Vorrichtung ist zum Trocknen von Wafern mehrerer Durchmesser geeignet, ohne erhöhten konstruktiven Aufwand.

## Beschreibung

Die vorliegende Erfindung bezieht sich auf ein Verfahren zur Herstellung verbesserter Oberflächen von III-V-Substraten, sowie die III-V-Substrate selbst, wobei hier hauptsächlich die Materialien GaAs und InP von besonderer Bedeutung sind.

### HINTERGRUND DER ERFINDUNG

III-V-Substrate, insbesondere Galliumarsenid-Substrate, insbesondere deren Wafer, werden für verschiedene Anwendungen verwendet und haben wirtschaftlich eine immer höhere Bedeutung. Beispiele hierfür sind Hochfrequenzverstärker und Schalter, allerdings auch Licht aussendende Komponenten sowie Halbleiterlaser und Dioden. Insbesondere Transistoren und Dioden werden insbesondere aus einkristallinen chemischen Verbindungen hergestellt, welche epitaktisch gewachsen sind. Wachstumsparameter können insbesondere an das Kristallgitter angepasst werden. Die Gitter-angepasste Epitaxie garantiert eine hohe Qualität und niedrige Defektdichten, die Qualität ist aber nicht nur von den Bedingungen während der Epitaxie abhängig, sondern ebenfalls von den Substrateigenschaften selbst, welche häufig die Qualität beeinflussen. Im Falle von Galliumarsenid tritt insbesondere das Problem auf, dass sich schnell eine Oxidschicht auf der Substratoberfläche bilden kann, welche sich, wenn keine richtige Oberflächenbehandlung stattfindet, inhomogen zusammengesetzt ausbilden kann (Galliumoxid und Arsenoxid unterschiedlicher Oxidationsstufen). Die thermischen Eigenschaften unterschiedlich zusammengesetzter Oxide sind z.T. sehr verschieden. Für nachfolgende Epitaxieprozesse muss jedoch garantiert sein, dass unter thermischen Bedingungen die Oxidschicht leicht wieder entfernt werden kann.

Im Stand der Technik ist beispielsweise das Dokument EP 2 629 319 A1 bekannt, aus welchem hervorgeht, dass insbesondere Galliumarsenid besondere physikalische und chemische Oberflächeneigenschaften aufweist, welche sich von anderen Halbleitern, wie beispielsweise Silizium, deutlich unterscheiden. Dadurch, dass die Oberfläche von einem Galliumarsenid-Wafer Galliumatome und Arsenatome enthält, welche verschiedene chemische Eigenschaften (auch hinsichtlich der Reaktivität) haben, ist die Oberflächenreaktivität hier ein besonderes Phänomen: Die Oberflächenschicht kann aus Galliumdioxid (Ga₂O₃), Arsentrioxid (As₂O₃), Arsenpentoxid (As₂O₅) und einem geringen Anteil aus elementarem Arsen bestehen. Wenn Galliumarsenid gewachsen wird, muss die Oberfläche mit einem bestimmten Verfahren hergestellt werden, welches in diesem Dokument beschrieben ist: Behandlung mit Ammoniaklösung, Wasserstoffperoxid und Wasser, Spülen des Wafers mit deionisiertem Wasser, Behandeln des Wafers mit einem Oxidationsmittel, wiederholtes Spülen des Wafers mit deionisiertem Wasser, Behandeln des Wafers mit einer verdünnten Säurelösung oder einer verdünnten Alkalilösung, erneutes Waschen des Wafers mit deionisiertem Wasser, und schließlich Trocknen des entsprechenden Wafers.

Bei der Oberflächenbehandlung von Galliumarsenid können sehr leicht Fremdpartikel anhaften, welche für spätere Epitaxieprozesse nachteilig sind, da sie eine verstärkte Defektanzahl hervorrufen würden. Weiterer Stand der Technik (Klaus Wolke et al., *"Marangoni wafer drying avoids disadvantages",* Solid State Technology, August 1996) beschreibt das Verfahren der Marangoni-Trocknung von Siliziumwafern. Hier wird offenbart, dass die Marangoni-Trocknung auf einer physikalischen Kraft beruht, die Flüssigkeiten von Flächen mit einer unterschiedlichen Oberflächenspannung bewegt, und daher ein Gleichgewicht herstellt. Geringe Mengen Wasser mit einer niedrigen Oberflächenspannung (welche absorbiertes Isopropanol enthalten) bewegen sich in eine Bulk-Flüssigkeit, welche eine normale Oberflächenspannung hat. Beispielsweise kann eine Isopropanol-Stickstoff-Atmosphäre verwendet werden, die eine niedrige Oberflächenspannung aufweist. Normales Wasser hat hingegen eine höhere Oberflächenspannung. Wasser bildet einen positiven Meniskus aus, wenn Feststoffe die Gas-Flüssigkeit-Grenzfläche durchschreiten, wenn die Wafer beispielsweise aus einem Bad entfernt werden. Wenn wasserlösliche Materialien wie z.B. Isopropanol in der Atmosphäre vorhanden sind, findet sich eine höhere Konzentration des Lösungsmittels im Meniskus, verglichen mit dem Rest des Bades. Wenn also ein Wafer aus dem Bad herausgeschoben wird, wird das Wasser im Meniskus in die Bulk-Flüssigkeit heruntergezogen, und eine komplett trockene Waferoberfläche ist das Ergebnis, wobei keine anhaftenden Wassertopfen auf der Waferoberfläche auftreten, welche sogenannte Wasserflecken hervorrufen können.

Der Marangoni-Effekt entsteht also durch einen Unterschied in der Grenzflächenspannung. Ein Fluid, in diesem Fall das Wasser, strömt dann entlang des Wafers in Richtung der größeren Spannung, was dazu führt, dass Wasser vom Wafer so entfernt wird und der Wafer so ohne Rückstände trocknen kann.

Die Marangoni-Trocknung von Halbleiterwafern beruht auf der räumlichen Trennung von Wafern und Reinstwasser unter der Wirkung eines Gradienten in der Oberflächenspannung in der den Wafer berührenden Grenzschicht des Reinstwassers. Die räumliche Trennung kann durch Heben der Wafer aus einem mit Reinstwasser gefüllten Prozessbecken einer Nassprozessanlage für Halbleiterwafer oder durch Absenken des Wasserspiegels erfolgen.

Im Dokument WO 2014/124980 A2 wird ein Verfahren zur Herstellung von GaAs-Substraten und ein daraus hergestelltes Galliumarsenid-Substrat offenbart, wobei das Verfahren die Marangoni-Trocknung beinhaltet. Es wurde hierbei festgestellt, dass bestimmte Oberflächenreinigungsschritte (saure Reinigung, alkalische Reinigung, Kontaktieren mit einem Oxidationsmittel) in Kombination mit der Marangoni-Trocknung dazu beitragen, dass die Homogenität der Oxidoberfläche stark verbessert wird, verglichen mit Verfahren, in welchen keine Marangoni-Trocknung als Trocknungsverfahren nach den Reinigungsschritten verwendet wird. Die Defektanzahl und die Defektfläche auf der Waferoberfläche konnten so im Vergleich mit einem Verfahren, welches keine Marangoni-Trocknung verwendet, massiv gesenkt werden. Hier werden als Defektflächen diejenigen Flächen gezählt, bei denen das Messignal einer Candela-Ellipsometrie außerhalb von definierten Schwellwerten liegen. Das ist eine Standardfunktion des Candela-Ellipsometers und wird vom Gerät direkt ausgegeben.

Die Marangoni-Trocknung eignet sich sehr gut für die Trocknung von HalbleiterWafern nach einer nasschemischen Reinigung. Die Trocknung erfolgt dabei vorzugsweise ganzflächig gleichmäßig und weitgehend rückstandsfrei.

Vor Beginn der Trocknung stehen die Halbleiter-Wafer üblicherweise senkrecht in einem Prozess-Carrier, der sich in einem mit deionisiertem Wasser gefüllten Prozessbecken befindet. Oftmals handelt es sich bei diesem Becken um das letzte Becken einer sogenannten Wetbench: einer Reihe von sequentiell angeordneten, mit Flüssigkeit gefüllten Becken, in denen die Wafer den für die Reinigung notwendigen Chemie- und Spülschritten unterworfen werden. In der hochproduktiven HalbleiterIndustrie werden die Prozess-Carrier mit den Wafern in der Regel von einem automatischen Handlingssystem nach Ablauf der jeweils vorgesehenen Prozesszeit von Becken zu Becken gesetzt.

Die Trocknung nach dem Marangoni-Verfahren existiert in verschiedenen Ausführungsformen. Allen Marangoni-Verfahren liegen jedoch gemeinsame Grundprinzipien zugrunde:
Eine zur Erniedrigung der Oberflächenspannung des im Becken befindlichen Wassers geeignete Flüssigkeit wird auf die Wasseroberfläche gebracht. In der Regel handelt es sich dabei um Iso-Propyl-Alkohol (Iso-Propanol, abgekürzt: IPA).

Die eigentliche Trocknung erfolgt durch die langsame räumliche Trennung von Wafern und der oberen Wasserschicht mit ihrer durch das Isopropanol verringerten Oberflächenspannung. Diese räumliche Trennung kann auf unterschiedliche Weise erfolgen, wie beispielsweise durch Ausheben der Wafer aus dem Wasser, durch Absenken des Wasserspiegels oder eine Kombination aus beidem.

Für ein gutes Trocknungsergebnis liegt die relative Geschwindigkeit der Entfernung von Wafern und Wasserspiegel im Bereich von zum Beispiel 1 mm/s.

An den zwangsweise verbleibenden Kontaktstellen zwischen Wafer und Haltevorrichtung können bei deren Durchtritt durch die Phasengrenze während der Marangoni-Trocknung Wassertropfen, sogenannte Resttropfen, haften bleiben, welche zu einer chemisch veränderten und damit die kristalline Qualität der auf den Wafern im Rahmen der Bauelement-Herstellung abzuscheidenden Epitaxieschichten negativ beeinflussenden Oxidschicht führen können. Verzögert und unkontrolliert trocknendes Wasser kann Schäden auf der Waferoberfläche verursachen.

Bei der Weiterverarbeitung der Halbleiterwafer zu elektronischen oder optischen Bauelementen können im Rahmen der sogenannten Planar-Technologie extrem oberflächenempfindliche Beschichtungsprozesse zum Einsatz kommen, bei denen dünne Halbleiter-Schichten in einkristalliner Form auf der Oberfläche der Wafer abgeschieden werden. Dieser als Epitaxie bezeichnete Prozess stellt extrem hohe Anforderungen an die Oberflächenqualität der Halbleiterwafer.

Sogenannte III-V-Halbleiter und insbesondere GaAs und InP zeichnen sich im Vergleich beispielsweise mit Silizium-Wafern durch eine veränderte Oberflächenspannung, eine deutlich erhöhte Oberflächenreaktivität und eine komplexere chemische Zusammensetzung der Oxidschicht aus. Die vorzugsweise Weiterverarbeitung dieser Wafer mittels der einkristallinen Beschichtung mit anderen III-V-Materialien stellt zudem erheblich höhere Anforderungen an die laterale Gleichmäßigkeit der Zusammensetzung der Oxidschicht als bei Silizium-Wafern. Resttropfen während der Marangoni-Trocknung können also bei III-V-Halbleiterwafern leichter entstehen und haben eine stärker negative Auswirkung auf die nachfolgenden Prozesse im Rahmen der Bauelement-Herstellung.

In trockenem Zustand ist die Oberfläche bestimmter Halbleiterwafer (insbesondere GaAs und InP) immer mit einer dünnen, nicht kristallinen Oxidschicht bedeckt. Diese Schicht ist in der Regel nur 1 bis 2 Nanometer dick (bei InP sind sogar Schichtdicken unter 1 nm möglich) und besteht demzufolge nur aus wenigen Atomlagen. Während der nasschemischen Reinigungs- und Spülprozesse unterliegt die Oxidschicht komplexen Veränderungen, wird entfernt, wieder erzeugt oder in ihrer Zusammensetzung verändert.

Die nach den Reinigungs-, Spül- und Trocknungsprozessen auf der Waferoberfläche entstandene Oxidschicht besitzt eine passivierende Wirkung und wird in einigen Anwendungsbereichen erst unmittelbar vor der epitaktischen Beschichtung thermisch von der Waferoberfläche entfernt.

Eine optimale und lateral gleichmäßige Zusammensetzung der Oxidschicht ist jedoch eine entscheidende Voraussetzung, damit die nach der thermischen Desorption der Oxidschicht verbleibende Startoberfläche für die Epitaxie ganzflächig eine bestmögliche kristallografische Ankopplung der abzuscheidenden Schichten, und auf diese Weise einen optimalen Stromfluss in den später aus diesen Epitaxie-Schichten erzeugten Bauelementen, ermöglicht.

Nach der Marangoni-Trocknung verbleibende, verzögert und unkontrolliert eintrocknende Wassertropfen verursachen in den betroffenen Bereichen der Waferoberfläche eine ungünstig veränderte Zusammensetzung der Oxidschicht mit teilweise kristallinen Bereichen. In den derart gestörten Teilen der Waferoberfläche kann es bei der Desorption vor dem Epitaxievorgang zu einer unvollständigen Desorption des Oberflächenoxids und als Folge zu einer Aufrauhung der Waferoberfläche kommen. Das einkristalline Wachstum der funktionalen Schichten wird daraufhin gestört, und es kommt zur Entstehung von Kristallfehlern wie Versetzungen, Korngrenzen oder Zwillingslamellen. Dadurch wird schließlich der Stromfluss in den aus dem epitaktisch aufgewachsenen Material erzeugten Bauelementen gestört, und es kann zu Ausbeuteverlusten kommen.

Beim Marangoni-Trocknungsverfahren bestehen grundsätzlich verschiedene Möglichkeiten, wie ein Wafer nach der Oberflächenbehandlung getrocknet werden kann und wie ein Wafer aus dem Bad herausgezogen werden kann.

Bei einer Variante wird ein Wafer oder eine Gruppe von Wafern von einer Horde (Halteanordnung mit Stäben) im Wasserbad gehalten. Bei dieser ersten Variante wird das Spülwasser (meistens nach dem Reinigungsschritt mit deionisiertem Wasser) abgelassen; im Rahmen der vorliegenden Erfindung wurde allerdings erkannt, dass an den Kontaktstellen des Wafers oder der Wafer, an welcher dieser von der Horde gehalten werden, häufig Resttropfen auftreten, bei welchen die homogene Trocknung gestört wird. Die Qualität der Oberflächenschicht der Oxidschicht auf der Oberfläche des Wafers lässt also lokal nach, die Oberflächen-Oxidschicht wird inhomogen, was bei später aufgewachsenen Epitaxieschichten zu einer geringeren Qualität führt.

In der zweiten Variante werden die Wafer durch einen vertikal nach oben geschobenen Keil aus dem Wasserbad gehoben, die Wafer werden zeitweise durch diesen Keil sowie durch Waferaufnahmen, beispielsweise im Deckel des Trockners, gehalten. Bei dieser Variante wurde im Rahmen der vorliegenden Erfindung erkannt, dass an vielen Kontaktstellen Resttropfen vermieden werden können, meist ist aber beim Durchqueren der Wasseroberfläche ein Tropfen im Bereich des Keils vorhanden. Ferner können aufgrund der fixen Anordnung der Waferhalterung im Deckel des Trockners nur Wafer mit einem bestimmten Waferdurchmesser getrocknet werden.

Weitere Verfahren zum Herausheben eines Wafers oder einer Gruppe von Wafern aus einem Reinigungsbad sind im Dokument WO 2001/078112 A1 offenbart. Hier sind zwei gegenüberliegende Greifelemente mit zueinander weisenden Aufnahmespitzen vorhanden, diese Greifarme können Wafer greifen, wenn diese von einem Keil aus der Wasseroberfläche geschoben werden.

Ferner ist im Dokument DE 199 243 02 A1 ein Verfahren zum Trocknen von Substraten gemäß dem Marangoni-Effekt offenbart. Hier wird beim Ausbringen des Substrats aus dem Behandlungsfluid wenigstens ein weiteres Fluid seitlich zum Substrat und auf das Behandlungsfluid aufgebracht und in zwischen den Substraten liegende Bereiche geleitet.

Ferner ist aus dem Dokument DE 10 359 320 A1 ein Verfahren zum Trocknen von Substraten bekannt, wobei Substrate aus dem Bad der Behandlungsflüssigkeit ausgebracht und in ein in die Oberflächenspannung der Behandlungsflüssigkeit verringerndes Fluid auf die Behandlungsflüssigkeit durch wenigstens zwei einander gegenüberliegender zueinander gerichteten Zuführeinrichtung aufgebracht wird, was dazu führt, dass die Zufuhr des die Oberflächenspannung der Behandlungsflüssigkeit verringernden Fluids derart gesteuert wird, dass die gegenüberliegenden Zuführeinrichtungen abwechselnd mit Fluid beaufschlagt werden.

Die aus dem Stand der Technik bekannten Verfahren sind häufig apparativ aufwändig; sie sind nach wie vor mit dem Nachteil verbunden oder nehmen diesen sogar bewusst in Kauf, dass beim Ausheben der Wafer aus dem Behandlungsfluid Resttropfen verbleiben, welche "Flecken" auf dem Wafer hervorrufen, so dass nachfolgendes epitaktisches Wachstum von dickeren Kristallschichten durch Flecken gestört werden kann. Im Rahmen der vorliegenden Offenbarung bedeuten "Flecken" Oberflächendefekte, welche aus am Wafer anhaftenden Tropfen entstanden sind und mithilfe der Candela-Oberflächenellipsometrie detektierbar sind.

"Flecken" bedeuten zum Beispiel chemisch gesehen auf der Waferoberfläche eine veränderte Oberflächenoxidzusammensetzung verglichen mit den Stellen, an denen keine derartigen Flecken auftreten.

Es ist daher eine Aufgabe der vorliegenden Erfindung, ein Verfahren bereitzustellen, welches apparativ nicht aufwendig ist und leicht zu realisieren ist, mit welchem Wafer verschiedener Größe getrocknet werden können und bei welchen das Bilden von Resttropfen während dem Ausheben der Wafer minimiert oder nach Möglichkeit ganz vermieden werden kann. Das Bereitstellen von III-V-Wafern mit sehr homogener Oxidoberfläche kann als eine weitere Aufgabe der vorliegenden Erfindung angesehen werden.

### ZUSAMMENFASSUNG DER ERFINDUNG

Diese Aufgabe wird gelöst durch ein Verfahren gemäß dem Anspruch 1, einem III-V-Wafer gemäß Anspruch 14 oder 16 sowie einer Vorrichtung zum Trocknen von Wafern gemäß Anspruch 18. Weitere vorteilhafte Ausgestaltungen der vorliegenden Erfindung sind Gegenstand der entsprechenden Unteransprüche.

Zur Charakterisierung der Oberflächeneigenschaften der entsprechenden Wafer wurden ellipsometrische Oberflächen-Mappings, welche mit einem Candela-Oberflächenellipsometer durchgeführt wurden, verwendet. Details der entsprechenden Messungen werden entsprechend in der Beschreibung und den Beispielen erläutert.

Ohne die Erfindung einzuschränken, werden die folgenden Punkte zur Beschreibung von Hauptaspekten, bevorzugten Ausführungsformen und besonderen Eigenschaften der vorliegenden Erfindung wie folgt wiedergegeben:
1. Verfahren zum Trocknen eines Wafers (W), welcher sich in einem Bad (1) befindet, mithilfe einer Anordnung, welche mindestens einen Keil (2) sowie ein Paar von ersten seitlichen Führungsvorrichtungen (3a, 3a'), ein Paar von zweiten seitlichen Führungsvorrichtungen (3b, 3b') sowie ein Paar von dritten seitlichen Führungsvorrichtungen (3c, 3c') aufweist,
   wobei das Paar von ersten seitlichen Führungsvorrichtungen (3a, 3a') unterhalb des Paars von zweiten seitlichen Führungsvorrichtungen (3b, 3b') angeordnet ist, und das Paar von zweiten seitlichen Führungsvorrichtungen (3b, 3b') unterhalb des Paars von dritten seitlichen Führungsvorrichtungen (3c, 3c') angeordnet ist, und
   wobei das Verfahren die folgenden Schritte aufweist:
      i) Vertikales Bewegen des mindestens eines Keils (2) nach oben, bis dieser den Wafer an dessen unterstem Punkt berührt, vertikales Bewegen des Paars von ersten seitlichen Führungsvorrichtungen (3a, 3a') und des Paars von zweiten seitlichen Führungsvorrichtungen (3b, 3b') nach oben,
         wobei der Wafer (W) das Paar von ersten seitlichen Führungsvorrichtungen (3a) und das Paar von zweiten seitlichen Führungsvorrichtungen (3b) berührt, wobei ein oberer Bereich des Wafers (W) aus dem Bad (1) hinausgeschoben wird, wobei das Paar von dritten seitlichen Führungsvorrichtung (3c) den Wafer nicht berührt;
      ii) Vertikales Bewegen des Keils (2) nach oben, bis das Paar von ersten seitlichen Führungsvorrichtungen (3a, 3a') sowie das Paar von zweiten seitlichen Führungsvorrichtungen (3b, 3b') den Wafer (W) nicht mehr berühren, während sie sich noch unter der Flüssigkeitsoberfläche des Bades (1) befinden, wobei das Paar von dritten seitlichen Führungsvorrichtungen (3c, 3c') den Wafer oberhalb der Flüssigkeitsoberfläche des Bades (1) berührt;
      iii) Herausschieben des Wafers (W) oberhalb des Flüssigkeitsspiegels des Bads (1), wobei das Paar von dritten seitlichen Führungsvorrichtungen (3c, 3c') den Wafer (W) berührt.
   **In** einer Ausführungsform ist der Abstand des Paars von ersten seitlichen Führungsvorrichtungen (3a, 3a') voneinander kleiner als der Abstand des Paars von zweiten seitlichen Führungsvorrichtungen (3b, 3b') voneinander, und der Abstand des Paars von zweiten seitlichen Führungsvorrichtungen (3b, 3b') voneinander ist kleiner als der Abstand des Paars von dritten seitlichen Führungsvorrichtungen (3c, 3c') voneinander.
2. Verfahren zum Trocknen eines Wafers (W) gemäß Punkt 1, ferner die folgenden Schritte umfassend:
   iv) Vertikales Bewegen eines Keils (2) nach unten, bis der Wafer (W) mindestens eine des Paars von ersten seitlichen Führungsvorrichtungen (3a) und des Paars von zweiten seitlichen Führungsvorrichtungen (3b) berührt;
   v) Weiteres vertikales Bewegen eines Keils (2) nach unten, bis dieser den Wafer (W) nicht mehr berührt;
   wobei parallel zu den Schritten iv) und/oder v) oder nach dem Schritt v) der Flüssigkeitsspiegel des Bads (1) abgesenkt wird, bis der Flüssigkeitsspiegel sich unterhalb des Keils (2) befindet.
3. Verfahren gemäß Punkt 1 oder 2, wobei das Bad Wasser sowie mindestens eine weitere oberflächenspannungsreduzierende Substanz enthält.
4. Verfahren gemäß Punkt 3, wobei mindestens eine weitere oberflächenspannungsreduzierende Substanz Isopropanol ist.
5. Verfahren gemäß einem der vorhergehenden Punkte 2 bis 4, wobei in Schritt i) das Paar von ersten seitlichen Führungsvorrichtungen (3a, 3a') sowie das Paar von zweiten seitlichen Führungsvorrichtungen (3b, 3b') im Bad (1) eingetaucht bleiben, und vorzugsweise am Ende des Schritts v) das Paar von dritten seitlichen Führungsvorrichtungen (3c, 3c') den Wafer (W, W1, W2) nicht berührt.
6. Verfahren gemäß einem der vorhergehenden Punkte, wobei das Paar von ersten seitlichen Führungsvorrichtungen (3a, 3a'), das Paar von zweiten seitlichen Führungsvorrichtungen (3b, 3b') und/oder das Paar von dritten seitlichen Führungsvorrichtungen (3c, 3c') jeweils aus einem Paar Stege besteht, welche dazu angepasst sind, gegenüberliegende Seiten des Wafers (W) zu berühren.
7. Verfahren gemäß einem der vorhergehenden Punkte, wobei das Paar von ersten seitlichen Führungsvorrichtungen (3a, 3a'), das Paar von zweiten seitlichen Führungsvorrichtungen (3b, 3b') und optional das Paar von dritten seitlichen Führungsvorrichtungen (3c, 3c') ferner von einer Trägervorrichtung (3d) gehalten werden, so dass eine vertikale Bewegung des Paars von ersten seitlichen Führungsvorrichtungen (3a, 3a'), des Paars von zweiten seitlichen Führungsvorrichtungen (3b, 3b') und optional des Paars von dritten seitlichen Führungsvorrichtungen (3c, 3c') stets synchron erfolgt.
8. Verfahren gemäß einem der vorhergehenden Punkte, wobei in Schritt i) das Paar von ersten seitlichen Führungsvorrichtungen (3a, 3a') sowie das Paar von zweiten seitlichen Führungsvorrichtungen (3b, 3b') im Bad (1) eingetaucht bleiben.
9. Verfahren gemäß einem der vorhergehenden Punkte 2 bis 8, wobei am Ende des Schritts iv) und v) das Paar von dritten seitlichen Führungsvorrichtungen (3c, 3c') den Wafer (W) nicht berührt.
10. Verfahren gemäß einem der vorhergehenden Punkte, wobei der Schritt ii) weiterhin das Fixieren des Wafers durch eine zusätzliche Greifvorrichtung (4) beinhaltet, welche oberhalb des Flüssigkeitsspiegels des Bades (1) vorgesehen ist.
11. Verfahren gemäß einem der vorhergehenden Punkte, wobei der Keil (2) mit Absaugvorrichtungen (6) versehen ist, an welche ein Unterdruck angelegt wird, wenn sich die obere Spitze des Keils (2) oberhalb des Flüssigkeitsspiegels befindet.
12. Verfahren gemäß Punkt 11, wobei die Absaugvorrichtungen (6) Öffnungen im Keil (2, 2a, 2b) sind.
13. Verfahren gemäß einem der vorhergehenden Punkte, wobei der Keil (2) aus Kunststoff, vorzugweise Polyetheretherketon (PEEK), gefertigt ist.
14. Verfahren gemäß einem der vorhergehenden Punkte, wobei der Keil (2) eine oberflächenspannungserhöhende Oberflächenstruktur aufweist. Diese wird beispielsweise durch eine Plasmabehandlung erreicht.
15. Verfahren gemäß einem der vorhergehenden Punkte, wobei das Paar von ersten seitlichen Führungsvorrichtungen (3a, 3a'), das Paar von zweiten seitlichen Führungsvorrichtungen (3b, 3b') sowie das Paar von dritten seitlichen Führungsvorrichtungen (3c, 3c') Zacken aufweist.
16. Verfahren gemäß einem der Punkte 1 bis 15, wobei die Aushebegeschwindigkeit abhängig von der Position des untersten Punkts des Wafers (W) ist,
   und zwischen 0,8 und 1,2 mm/s beträgt, wenn der unterste Punkt des Wafers (W) mehr als 1,2 cm unter dem Flüssigkeitsspiegel liegt, zwischen 0,4 und 0,5 mm/s beträgt, wenn der unterste Punkt des Wafers (W) weniger als 1,2 cm unter dem Flüssigkeitsspiegel liegt, und mindestens 30 mm/s, vorzugsweise mindestens 40 mm/s, weiter vorzugsweise mindestens 50 mm/s beträgt, sobald der unterste Punkt des Wafers (W) den Flüssigkeitsspiegel erreicht hat.
17. Verfahren gemäß einem der Punkte 1 bis 16, wobei das Paar von ersten seitlichen Führungsvorrichtungen (3a, 3a'), das Paar von zweiten seitlichen Führungsvorrichtungen (3b, 3b') sowie das Paar von dritten seitlichen Führungsvorrichtungen (3c, 3c') an einer Horde (3) vorgesehen ist, und in Schritt i) die Horde (3) bewegt wird, in Schritt iii) der Wafers (W) oberhalb den Flüssigkeitsspiegels des Bads (1) herausgeschoben wird, wobei das Paar von dritten seitlichen Führungsvorrichtungen (3c, 3c') und der Keil (2) den Wafer (W) berühren.
18. Verfahren gemäß einem der Punkte 1 bis 16, wobei das Paar von dritten seitlichen Führungsvorrichtungen (3c, 3c') in allen Verfahrensschritten oberhalb des Flüssigkeitsspiegels positioniert ist und unabhängig von dem Paar von ersten seitlichen Führungsvorrichtungen (3a, 3a') und dem Paar von zweiten seitlichen Führungsvorrichtungen (3b, 3b') beweglich ist, und die dritten seitlichen Führungsvorrichtungen (3c, 3c') relativ zueinander horizontal beweglich sind.
19. Verfahren gemäß Anspruch 18, wobei der Keil (2) in allen Verfahrensschritten unterhalb des Flüssigkeitsspiegels bleibt.
20. Verfahren gemäß einem der Punkte 18 oder 19, wobei in Schritt iii) der Abstand der Punkte, an denen die dritten seitlichen Führungsvorrichtungen (3c, 3c') den Wafer berühren, stetig verringert wird.
21. Verfahren gemäß einem der Punkte 18 bis 20, wobei die dritten seitlichen Führungsvorrichtungen (3c, 3c') dazu angepasst sind, eine horizontale Bewegung relativ zueinander auszuführen.
22. Verfahren gemäß einem der Punkte 18 bis 21, wobei die dritten seitlichen Führungsvorrichtungen (3c, 3c') entweder azentrisch gelagert sind oder eine ovale Form aufweisen und dazu angepasst sind, eine Drehbewegung auszuführen.
23. III-V-Wafer (W), wobei mindestens eine Oberfläche das Wafers eine Oxidschicht aufweist, wobei diese Oberfläche bzw. deren Oxidschicht eine Defektfläche von unter 25 mm² aufweist, und wobei der III-V-Wafer (W) halbisolierend ist.
   Halbisolierend bedeutet für viele Verbindungen (wie z.B. GaAs), dass das Fermi-Niveau nahe der Mitte der Bandlücke liegt. Im Falle von GaAs kann der intrinsische Punktdefekt EL2 (Arsen-Antisite auf Galliumplatz) neben einer gewissen Dotierung mit Kohlenstoff (C) dafür sorgen. Im Falle von InP ist eine Dotierung mit Eisen notwendig, um halbisolierende Eigenschaften herzustellen.
   Für die Ladungsträgerkonzentration gilt: Bei einer Ladungsträgerkonzentration von unter 1x10¹⁰ cm⁻³ gelten Wafer als halbisolierend, bei einer Ladungsträgerkonzentration von über 1x10¹⁰ cm⁻³ halbleitend. Die Bestimmung der Ladungsträgerkonzentration ist in der Norm "SEMI M39" beschrieben.
   Der spezifische Widerstand beträgt laut Norm "SEMI M87" für halbisolierende Wafer mehr als 1x10⁵ Ωcm, unterhalb dieses Wertes können die Wafer als halbleitend angesehen werden.
24. III-V-Wafer (W) gemäß Punkt 23, wobei die Oxidoberfläche eine Defektfläche von unter 15 mm², vorzugsweise unter 10 mm², weiter vorzugsweise unter 5 mm² aufweist.
25. Mindestens einseitig endpolierter, getrockneter und halbisolierender III-V-Wafer (W) mit einer Oxidschicht auf der gesamten Oberfläche, wobei eine Oberfläche, die eine verglichen mit der übrigen Gesamtoberfläche des III-V-Wafers veränderte Oberflächenoxidzusammensetzung aufweist, weniger als 5 mm² beträgt.
   Eine Messung erfolgt hier durch die Candela-Oberflächenellipsometrie mit dem Messkanal QAbsPhase.
26. III-V-Wafer (W) gemäß Punkt 23, 24 oder 25, wobei das III-Element aus Ga und In ausgewählt ist, und das V-Element aus As und P ausgewählt ist.
27. III-V-Wafer (W) gemäß Punkt 26, wobei der III-V-Wafer aus GaAs oder InP besteht, wobei GaAs undotiert oder mit Kohlenstoff (C) dotiert sein kann bzw. das InP mit Eisen (Fe) dotiert sein kann.
28. III-V-Wafer (W) gemäß einem der Punkte 23 bis 27, wobei der spezifische Widerstand zwischen 1x10⁸ und 8x10⁸ Ωcm beträgt.
29. III-V-Wafer (W), wobei mindestens eine Oberfläche das Wafers eine Oxidschicht aufweist, wobei diese Oberfläche bzw. deren Oxidschicht eine Defektfläche von unter 25 mm² aufweist, und wobei der III-V-Wafer (W) halbleitend ist.
   Eine Messung erfolgt hier durch die Candela-Oberflächenellipsometrie mit dem Messkanal QAbsPhase.
   Für die Ladungsträgerkonzentration gilt: Bei einer Ladungsträgerkonzentration von unter 1x10¹⁰ cm⁻³ gelten Wafer als halbisolierend, bei einer Ladungsträgerkonzentration von über 1x10¹⁰ cm⁻³ halbleitend. Die Bestimmung der Ladungsträgerkonzentration ist in der Norm "SEMI M39" beschrieben.
30. III-V-Wafer (W) gemäß Punkt 29, wobei der III-V-Wafer (W) Silizium oder Schwefel als Dotierstoff enthält.
31. III-V-Wafer (W) gemäß Punkt 30, wobei der III-V-Wafer ein GaAs-Wafer ist und Silizium als Dotierstoff enthält.
32. III-V-Wafer (W) gemäß Punkt 30, wobei der III-V-Wafer ein InP-Wafer ist und Schwefel als Dotierstoff enthält.
33. Mindestens einseitig endpolierter, getrockneter halbleitender III-V-Wafer (W) mit einer Oxidschicht auf der gesamten Oberfläche, wobei eine Oberfläche, die eine verglichen mit der übrigen Gesamtoberfläche des III-V-Wafers (W) veränderte Oberflächenoxidzusammensetzung aufweist, weniger als 25 mm² beträgt.
   Eine Messung erfolgt auch hier durch die Candela-Oberflächenellipsometrie mit dem Messkanal QAbsPhase.
34. III-V-Wafer (W) gemäß einem der Punkte 29 bis 33, wobei die Ladungsträgerkonzentration zwischen 1x10¹⁸ cm⁻³ und 9x10¹⁸ cm⁻³ liegt.
35. InP-Wafer (W) gemäß einem der Punkte 29 bis 34, dessen Oxidoberfläche eine Defektfläche von unter 20 mm², vorzugsweise von unter 15 mm², weiter vorzugsweise von unter 10 mm², noch weiter vorzugsweise von unter 5 mm² aufweist.
36. III-V-Wafer (W) gemäß einem der vorhergehenden Punkte 23 bis 35, wobei der Waferdurchmesser mindestens 150 mm beträgt.
37. III-V-Wafer (W) gemäß einem der Punkte 23 bis 36, wobei der Waferdurchmesser mindestens 200 mm beträgt.
38. GaAs-Wafer (W), welcher mit Silizium dotiert ist, eine Ladungsträgerkonzentration zwischen 1x10¹⁸ cm⁻³ und 3x10¹⁸ cm⁻³, aufweist, und wobei die Oxidoberfläche eine Defektfläche von unter 25 mm² aufweist.
39. InP-Wafer (W), welcher mit Schwefel dotiert ist, eine Ladungsträgerkonzentration zwischen 1,5x10¹⁸ cm⁻³ und 9x10¹⁸ cm⁻³, aufweist, und wobei mindestens eine Oberfläche das Wafers eine Oxidschicht aufweist, wobei diese Oberfläche bzw. deren Oxidschicht eine Defektfläche von unter 25 mm² aufweist.
40. InP-Wafer (W), welcher mit Schwefel dotiert ist, eine Ladungsträgerkonzentration zwischen 1,5x10¹⁸ cm⁻³ und 9x10¹⁸ cm⁻³, aufweist, und wobei mindestens eine Oberfläche das Wafers eine Oxidschicht aufweist, wobei diese Oberfläche bzw. deren Oxidschicht eine Defektfläche von unter 20 mm², vorzugsweise von unter 15 mm², weiter vorzugsweise von unter 10 mm², noch weiter vorzugsweise von unter 5 mm² aufweist.
41. III-V-Wafer (W) gemäß einem der Punkte 23 bis 39 oder InP-Wafer gemäß einem der Punkte 39 oder 40, wobei die Defektfläche ein zusammenhängender Bereich ist.
42. III-V-Wafer (W) gemäß Punkt 41, wobei zumindest ein Teil der Defektfläche den Rand des Wafers kontaktiert.
43. III-V-Wafer (W) gemäß Punkt 41 oder 42, wobei mindestens ein Teil der Defektfläche max. 5 mm vom Rand des Wafers entfernt ist.
44. III-V-Wafer (W) gemäß einem der Punkte 41 bis 43, wobei sich mindestens ein Teil der Defektfläche in einem Kreisring zwischen dem Rand des Wafers und einer virtuellen kreisförmigen Linie, welche max. 10 mm vom Rand des Wafers entfernt ist, befindet.
45. III-V-Wafer (W) gemäß einem der Punkte 41 bis 44, wobei sich die gesamte Defektfläche in einem Kreisring zwischen dem Rand des Wafers und einer virtuellen kreisförmigen Linie, welche max. 10,5 mm vom Rand des Wafers entfernt ist, befindet.
46. III-V-Wafer (W) gemäß einem der Punkte 41 bis 45, wobei sich die gesamte Defektfläche in einem Kreisring zwischen dem Rand des Wafers und einer virtuellen kreisförmigen Linie, welche max. 10 mm vom Rand des Wafers entfernt ist, befindet.
47. III-V-Wafer (W) gemäß einem der Punkte 41 bis 46, wobei der Wafer an einem Teil des Randes einen gerade geschliffenen Abschnitt oder eine Kerbe hat, und die Defektfläche dem gerade geschliffenen Abschnitt oder der Kerbe gegenüberliegt.
   Der gerade geschliffene Abschnitt oder die Kerbe diesen als "Erkennungsmerkmal" zum Übertrag der beim Waferhersteller röntgenographisch bestimmten azimutalen Ausrichtung des Kristallgitters auf die Belichtungsanlagen in einer Litografielinie, wenn der Wafer für die Herstellung elektrischer Bauteile verwendet wird (Aufwachsen von Epitaxieschicht auf Wafer, Litografie usw.)..
48. Vorrichtung zum Trocknen von Wafern, umfassend:
   ein Bad (1) mit Flüssigkeit;
   einen Keil (2),
   mindestens eine Lagervorrichtung (5), welche vertikal verfahrbar ist;
   wobei mindestens eine Horde (3; 31, 32) in die Lagervorrichtung (5) einsetzbar ist,
   wobei die mindestens eine Horde (3; 31, 32) umfasst:
      ein Paar von ersten seitlichen Führungsvorrichtungen (3a, 3a'), ein Paar von zweiten seitlichen Führungsvorrichtungen (3b, 3b') sowie ein Paar von dritten seitlichen Führungsvorrichtungen (3c, 3c'),
      wobei das Paar von ersten seitlichen Führungsvorrichtungen (3a, 3a') unterhalb des Paars von zweiten seitlichen Führungsvorrichtungen (3b, 3b') angeordnet ist, und das Paar von zweiten seitlichen Führungsvorrichtungen (3b, 3b') unterhalb des Paars von dritten seitlichen Führungsvorrichtungen (3c, 3c') angeordnet ist, und
      wobei der Abstand des Paars von ersten seitlichen Führungsvorrichtungen (3a, 3a') voneinander kleiner ist als der Abstand des Paars von zweiten seitlichen Führungsvorrichtungen (3b, 3b') voneinander, und der Abstand des Paars von zweiten seitlichen Führungsvorrichtungen (3b, 3b') voneinander kleiner ist als der Abstand des Paars von dritten seitlichen Führungsvorrichtungen (3c, 3c') voneinander,
      wobei der Keil (2) unterhalb der Horde (3) vorgesehen ist und vertikal getrennt von der Lagervorrichtung (5) verfahrbar ist.
   Vertikal heißt hier aus dem Bad heraus oder in das Bad hinein, d.h. parallel zur Schwerkraftrichtung.
49. Vorrichtung gemäß Punkt 48, wobei der Keil (2) unabhängig von der Lagervorrichtung (5) bzw. Horde (3) vertikal verfahrbar ist.
50. Vorrichtung gemäß Punkt 48 oder 49, wobei der Keil (2) mindestens zwei Keilabschnitte (2a, 2b) umfasst, wobei beide Keilabschnitte (2a,2b) getrennt voneinander vertikal verfahrbar sind;
51. Vorrichtung gemäß der Punkt 50, wobei in die Lagervorrichtung (5) mindestens eine erste Horde (31) so einsetzbar ist, dass die Mitte der mindestens ersten Horde (31) oberhalb der Spitze des ersten Keilabschnitts (2a) positioniert ist, und ferner eine zweite Horde (32) so einsetzbar ist, dass die Mitte der zweiten Horde (32) oberhalb der Spitze des zweiten Keilabschnitts (2b) positioniert ist.
52. Vorrichtung gemäß Punkt 51, wobei die erste Horde (31) dazu angepasst ist, einen Wafer (W1) mit einem ersten Durchmesser zu halten, und die zweite Horde (32) dazu angepasst ist, einen Wafer (W2) mit einem zweiten Durchmesser zu halten, wobei der erste Durchmesser kleiner ist als der zweite Durchmesser.
53. Vorrichtung gemäß einem der Punkte 50 bis 52, wobei die Spitze des ersten Keilabschnitts (2a) und/oder zweiten Keilabschnitts (2b) als Dreieck, vorzugsweise rechtwinkliges Dreieck ausgebildet ist.
54. Vorrichtung gemäß einem der Punkte 50 bis 53, während der erste Keilabschnitt (2a) zweigeteilt ist, und zwei Bereiche vorhanden sind, in welchen der erste Keilabschnitt (2a) und der zweite Keilabschnitt (2b) nebeneinander angeordnet sind.

### BESCHREIBUNG DER FIGUREN

Im Folgenden werden bevorzugte Ausführungsformen der vorliegenden Erfindung unter Bezugnahme auf die beiliegenden Figuren näher beschrieben.

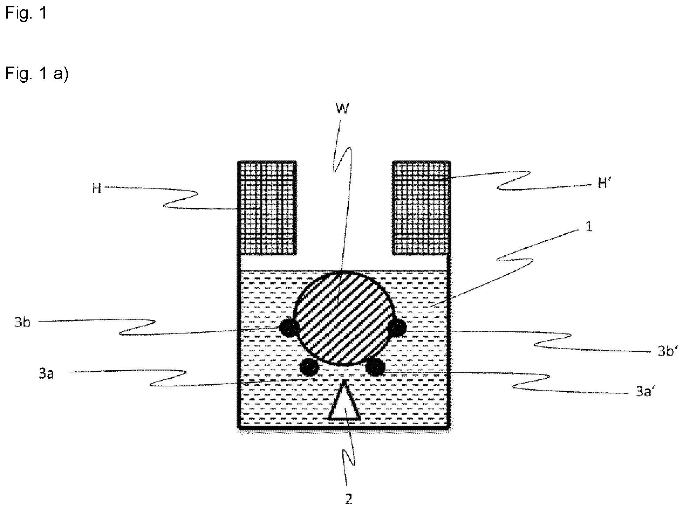

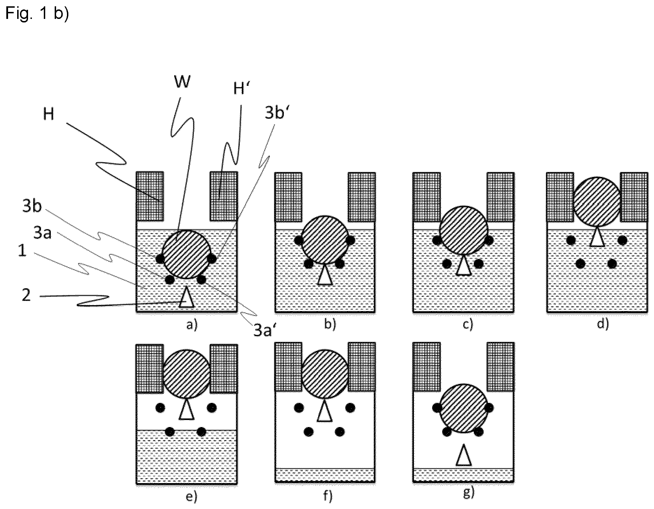

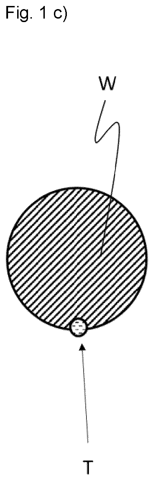

- Fig. 1: zeigt ein Marangoni-Trocknungsverfahren gemäß dem Stand der Technik.
- Fig. 1 a): zeigt eine Anordnung eines Wafers in einem Bad gemäß dem Stand der Technik,
- Fig. 1 b): zeigt die Abfolge der Verfahrensschritte, und
- Fig. 1 c): zeigt einen erhaltenen Wafer mit entsprechendem Resttropfen gemäß dem Stand der Technik.
- Fig. 2: zeigt ein weiteres Verfahren zur Marangoni-Trocknung gemäß dem Stand der Technik.
- Fig. 2a): zeigt eine Anordnung eines Wafers in einem Bad gemäß dem Stand der Technik,
- Fig. 2b): zeigt die Abfolge der Verfahrensschritte, und
- Fig. 2c): zeigt einen erhaltenen Wafer mit entsprechendem Resttropfen gemäß dem Stand der Technik.
- Fig. 3: zeigt ein erfindungsgemäßes Verfahren zur Herstellung eines gereinigten und getrockneten Wafers, beispielsweise GaAs-Wafer, mit einer Marangoni-Trocknung gemäß einer Ausführungsform.
- Fig. 3a): zeigt eine Anordnung eines Wafers in einem Bad,
- Fig. 3b): zeigt die Abfolge der Verfahrensschritte, und
- Fig. 3c): zeigt einen Resttropfen am Kontaktpunkt eines erhaltenen Wafers gemäß der erfindungsgemäßen Ausführungsform.
- Fig. 4: zeigt ein erfindungsgemäßes Verfahren zur Herstellung eines gereinigten und getrockneten Wafers, beispielsweise GaAs oder InP-Wafers, mit einer Marangoni-Trocknung gemäß einer weiteren Ausführungsform. Fig. 4 a) zeigt die Verfahrensschritte, Fig. 4 b) zeigt mögliche konstruktive Details für die Fixierung der Wafer oberhalb des Flüssigkeitsspiegels.
- Fig. 5: zeigt ein Detail der genauen Abfolge des Schritts d) aus Fig. 4 gemäß einer ersten Abwandlung.
- Fig. 6: zeigt ein Detail der genauen Abfolge des Schritts d) aus Fig. 4 gemäß einer zweiten Abwandlung.
- Fig. 7: zeigt ein Detail der genauen Abfolge des Schritts d) aus Fig. 4 gemäß einer dritten Abwandlung.
- Fig. 8: zeigt ein Konzept für den Schritts d) aus Fig. 4 gemäß einer vierten Abwandlung.
- Fig. 9: zeigt eine weitere Ausführungsform einer Vorrichtung zum Trocknen von Wafern.
- Fig. 10: zeigt zwei Beispiele von Horden, in welchen mehrere Wafer gehalten werden können.
- Fig. 11: zeigt ein Beispiel für eine Auswerteroutine von Wafern bzw. Wafergruppen, in welcher mit einem Candela-Oberflächenellipsometer aufgenommene Daten entsprechend verarbeitet werden.
- Fig. 12: zeigt mehrere Beispiele von Resttopfen bzw. deren Rückstände, welche mit einem Candela-Oberflächenellipsometer detektierbar sind und entsprechend hinsichtlich ihrer Fläche vermessen werden.
- Fig. 13: zeigt ein weiteres Beispiel für eine Auswerteroutine von Wafern bzw. Wafergruppen, in welcher mit einem Candela-Oberflächenellipsometer aufgenommene Daten entsprechend verarbeitet werden.
- Fig. 14: zeigt einen Vergleich zwischen halbisolierenden (in diesem Fall undotierten) GaAs-Wafern, welche mit Hilfe eines erfindungsgemäßen Verfahrens gemäß Fig. 3 getrocknet wurden, sowie Wafern, welche mit Hilfe eines Verfahrens gemäß Fig. 1 getrocknet wurden, hinsichtlich deren Defektfläche.
- Fig. 15: zeigt einen Vergleich zwischen halbleitenden (in diesem Fall Si-dotierten) GaAs-Wafern, welche mit Hilfe eines erfindungsgemäßen Verfahrens gemäß Fig. 3 getrocknet wurden, sowie Wafern, welche mit Hilfe eines Verfahrens gemäß Fig. 1 getrocknet wurden, hinsichtlich deren Defektfläche.
- Fig. 16: zeigt einen Vergleich zwischen halbleitenden (in diesem Fall mit Schwefel dotierten) InP-Wafern, welche mit Hilfe eines erfindungsgemäßen Verfahrens gemäß Fig. 3 getrocknet wurden, sowie Wafern, welche mit Hilfe eines Verfahrens gemäß Fig. 1 getrocknet wurden, hinsichtlich deren Defektfläche.
- Fig. 17: zeigt eine Ansicht auf eine Vorrichtung zum Trocknen von Wafern, von oben betrachtet.
- Fig. 18: zeigt Ansichten von der Seite auf eine Vorrichtung zum Trocknen von Wafern (in verschiedenen Zuständen), gemäß einer weiteren Ausführungsform der vorliegenden Erfindung.
- Fig. 19: zeigt einen Vergleich zwischen halbisolierenden (in diesem Fall Fe-dotierten) InP-Wafern, welche mit Hilfe eines erfindungsgemäßen Verfahrens gemäß Fig. 3 getrocknet wurden, sowie Wafern, welche mit Hilfe eines Verfahrens gemäß Fig. 1 getrocknet wurden, hinsichtlich deren Defektfläche.

Fig. 1 zeigt ein Verfahren zum Ausheben eines oder mehrerer Wafer(s) W aus einem Bad 1.

In Fig. 1a) ist ein Bad 1 gezeigt (dieses enthält beispielsweise deionisiertes Spülwasser, welchem eine oberflächenaktive Substanz wie zum Beispiel Isopropanol zugegeben wurde), hierin ist ein Wafer W enthalten. Oberhalb der Wasseroberfläche befinden sich Haltevorrichtungen H und H', und der Wafer W wird im Bad von zwei Paaren von seitlichen Führungsvorrichtungen 3a und 3a' sowie 3b und 3b' gehalten.

Unterhalb des Wafers befindet sich ein entsprechender Keil 2, welcher vertikal verfahrbar ist und beim Ausheben des Wafers verwendet wird.

In Fig. 1b) werden die Verfahrensschritte näher beschrieben.

Im Schritt a) des Verfahrens gemäß dem Stand der Technik befindet sich der Wafer W unterhalb der Flüssigkeitsoberfläche des Bades 1, auch die seitlichen ersten Führungsvorrichtungen 3a, 3a' sowie zweiten Führungsvorrichtungen 3b, 3b' befinden sich unter der Flüssigkeitsoberfläche. Der Keil 2 befindet sich unterhalb des Wafers W und berührt diesen nicht.

In Schritt b) wird, während die ersten und zweiten seitlichen Führungsvorrichtungen 3a, 3a', 3b, 3b' nach oben gefahren werden, der Keil 2 an den Wafer W herangefahren. Er muss diesen aber nicht zwingend berühren. Ein Teil des Wafers W befindet sich nun oberhalb der Flüssigkeitsoberfläche, die ersten und zweiten seitlichen Führungsvorrichtungen 3a, 3a', 3b, 3b' befinden sich jedoch noch unter der Flüssigkeitsoberfläche. Der Wafer W befindet sich in einem Zustand, in welchem er noch nicht von den Haltevorrichtungen H und H' gehalten werden kann. Er ist noch nicht aus dem Bad ausgehoben.

In Schritt c) wird lediglich der Keil 2 vertikal nach oben bewegt und schiebt den Wafer W teilweise aus dem Wasserbad heraus, der Wafer W berührt bereits die Haltevorrichtungen **H,** H'. Diese können beispielsweise im Deckel des Trockners vorgesehen sein. Die ersten und zweiten seitlichen Führungsvorrichtungen 3a, 3a', 3b, 3b' befinden sich jedoch noch unter der Flüssigkeitsoberfläche und haben sich im Vergleich zu Schritt b) nicht weiterbewegt. Dadurch, dass der Keil 2 den Wafer W weiter nach oben bewegt hat, berühren die ersten seitlichen Führungsvorrichtungen 3a, 3a' den Wafer W jedoch nicht mehr - die zweiten seitlichen Führungsvorrichtungen 3b, 3b' jedoch schon noch.

In Schritt d) wird der Wafer W noch weiter durch den Keil 2 nach oben geschoben - auch die zweiten seitlichen Führungsvorrichtungen 3b, 3b' berühren den Wafer W nun nicht mehr. Der Wafer W wird aber von den Haltevorrichtungen **H,** H' gehalten

In Schritt e) wird Flüssigkeit des Bades 1 abgelassen, die Flüssigkeitsoberfläche befindet sich unterhalb des Wafers W. Daher ist der Wafer W getrocknet. Damit die ersten und zweiten seitlichen Führungsvorrichtungen 3a, 3a', 3b, 3b' getrocknet werden können, wird der Wasserspiegel des Bades gesenkt, das Wasser wird somit abgelassen. Der Keil 2 berührt den Wafer W immer noch. Die ersten und zweiten seitlichen Führungsvorrichtungen 3a, 3a', 3b, 3b' haben sich im Vergleich zu Schritt c) nicht weiterbewegt.

In Schritt f) ist die Oberfläche des Wasserbads 1 so weit abgelassen, dass sich die ersten und zweiten seitlichen Führungsvorrichtungen 3a, 3a', 3b, 3b' und der Keil oberhalb der Flüssigkeitsoberfläche befinden und somit auch getrocknet sind. Der Keil 2 berührt den Wafer W immer noch.

In Schritt g) wird der Keil 2 abgesenkt. Durch die Bewegung des Keils 2 nach unten wird der Wafer W wieder von den bereits getrockneten ersten und zweiten seitlichen Führungsvorrichtungen 3a, 3a', 3b, 3b' gehalten und berührt diese daher.

Um einen Kontakt des Wafers W mit den ersten und zweiten seitlichen Führungsvorrichtungen 3a, 3a', 3b, 3b' während des Passierens der Flüssigkeitsoberfläche des Bades 1 zu vermeiden, wird der Wafer durch den sich nach oben bewegenden Keil 2 aus den ersten und zweiten Führungsvorrichtungen 3a, 3a', 3b, 3b' geschoben und wird anschließend nur noch von den Haltevorrichtungen H gehalten. Resttropfen zwischen Wafer und ersten und zweiten seitlichen Führungsvorrichtungen 3a, 3a', 3b, 3b' werden vermieden. Die Halterungen H, H' befinden sich jederzeit oberhalb des Wasserspiegels, und sind deswegen immer trocken und können keine Resttropfen verursachen. Beim Passieren des Wasserspiegels kann somit nur noch ein Resttropfen zwischen dem Wafer W und dem Keil 2 vorhanden sein.

Der Nachteil dieses Verfahrens ist allerdings, dass eine anspruchsvolle Prozessführung vorhanden ist, mit sehr hohen Anforderungen an die räumliche Justierung der beweglichen Teile zueinander, insbesondere des Keils 2 und der ersten und zweiten seitlichen Führungsvorrichtungen 3a, 3a', 3b, 3b'. Da die Haltevorrichtungen H, H' stets auf eine Größe eines Wafers eingestellt sind, können nach einem solchen Verfahren nicht Wafer mit unterschiedlichen Größen getrocknet werden - für jede Größe müsste somit ein eigener Trocknungsapparat vorhanden sein.

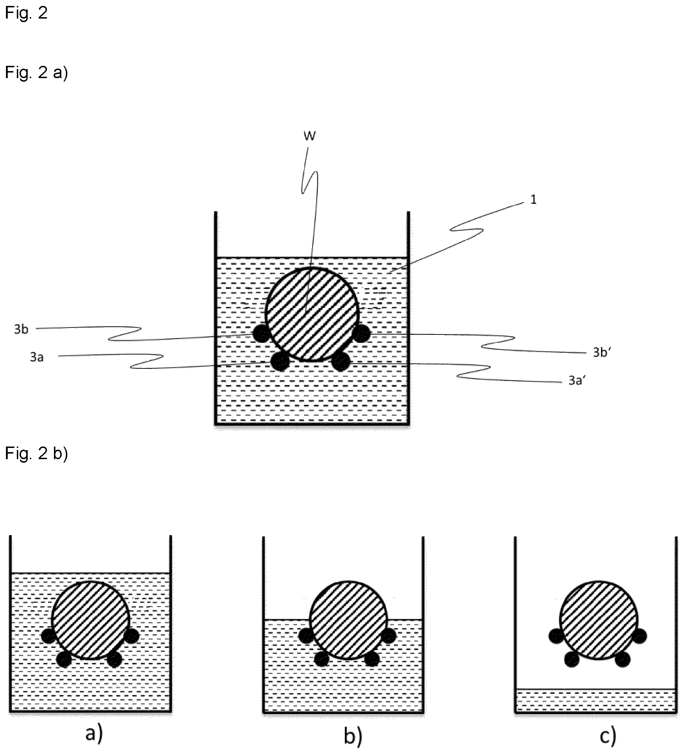

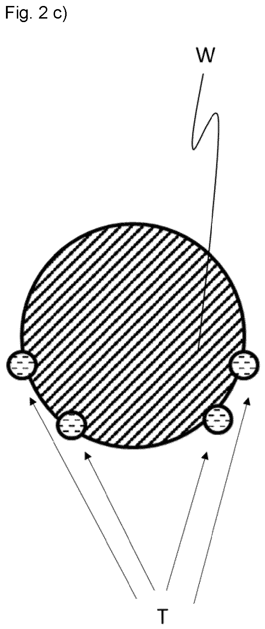

In Fig. 1c) wird deutlich, dass hier ein Resttropfen T am unteren Rand des Wafers W vorhanden ist, dieser entsteht zwischen dem Kontakt zwischen Wafer W und Keil 2. Fig. 2 zeigt ein alternatives Verfahren zum Trocknen eines oder mehrerer Wafer aus einem Bad 1, auch dieses Verfahren ist aus dem Stand der Technik bekannt.

Aus Fig. 2 a) wird deutlich, dass der Wafer W wiederum durch zwei Paare von ersten und zweiten seitlichen Führungsvorrichtungen 3a, 3a', sowie 3b, 3b' gehalten wird. Diese befinden sich wiederum in einem Bad 1.

Aus Fig. 2 b) gehen die einzelnen Schritte des Verfahrens hervor:
Im Schritt a) befindet sich der Wafer unter der Wasseroberfläche und wird von den ersten und zweiten seitlichen Führungsvorrichtungen 3a, 3a' sowie 3b, 3b' gehalten. Hier werden die ersten und zweiten seitlichen Führungsvorrichtungen 3a, 3a' und 3b, 3b' nicht bewegt. Das Wasserbad 1, welches Wasser enthält, welches an seiner oberflächennahen Schicht mit Isopropanol angereichert ist, wird mit einer vorbestimmten Geschwindigkeit abgelassen.

Im Schritt b) befindet sich die Flüssigkeitsoberfläche oberhalb des Paars von zweiten Führungseinrichtungen 3b, 3b'.

In Schritt c) befindet sich das Wasser unterhalb des Wafers W, die ersten und zweiten seitlichen Führungsvorrichtungen 3a, 3a' sowie 3b, 3b' sind oberhalb der Flüssigkeitsoberfläche.

Durch den Kontakt der ersten und zweiten seitlichen Führungsvorrichtungen 3a, 3a', 3b, 3b' beim Senken des Flüssigkeitsspiegels weisen die Kontaktstellen des Wafers mit den ersten und zweiten seitlichen Führungsvorrichtungen 3a, 3a', 3b, 3b' häufig Resttropfen auf, welche die Qualität der Wafer entsprechend beeinträchtigen. Auch die Qualität von anschließend aufgewachsenen Epitaxieschichten wird beeinträchtigt, dies kann zu einer schlechteren Ausbeute an Bauelementen führen. Ein Vorteil dieses Verfahrens ist allerdings, dass es technisch weniger anspruchsvoll ist, und auch die Trocknung von Wafern mit verschiedenen Größen ermöglicht.

Fig. 2 c) zeigt einen Wafer W mit Resttropfen T in allen vier Kontaktpunkten.

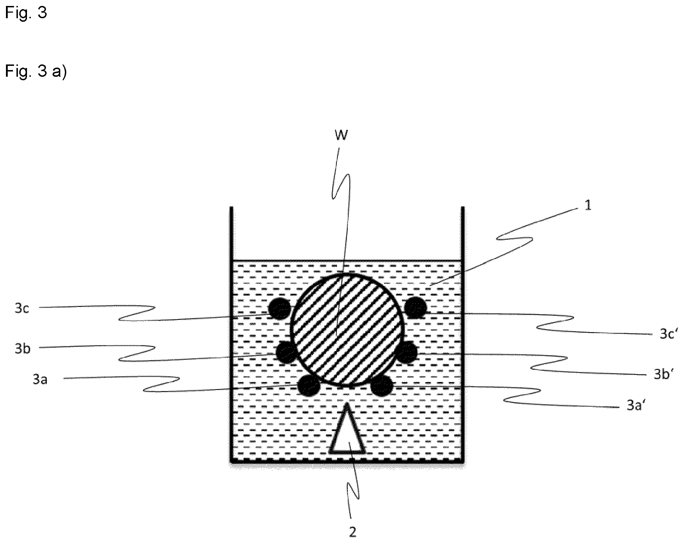

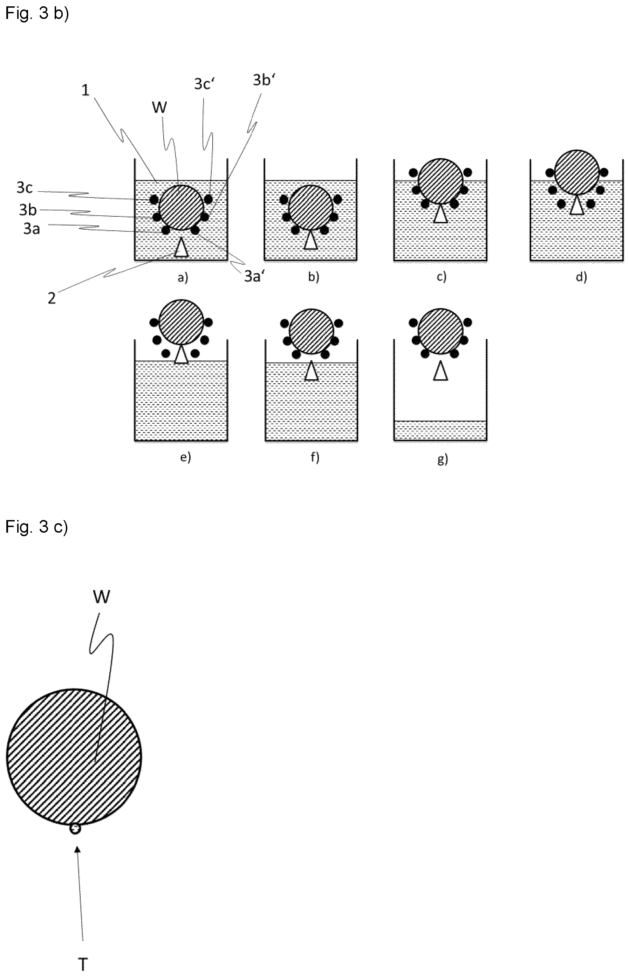

Fig. 3 zeigt ein Verfahren zur Wafer-Trocknung gemäß der vorliegenden Erfindung.

**In** Fig. 3a) ist ein Zustand gezeigt, in dem sich der Wafer W vollständig im Bad 1 befindet.

Hier sind allerdings drei Paare seitliche Führungseinrichtungen 3a, 3a', 3b, 3b', sowie 3c, 3c' vorhanden, welche den Wafer entsprechend halten, wobei das Paar von ersten seitlichen Führungsvorrichtungen 3a, 3a' unterhalb des Paars von zweiten seitlichen Führungsvorrichtungen 3b, 3b' angeordnet ist, und das Paar von zweiten seitlichen Führungsvorrichtungen 3b, 3b' unterhalb des Paars von dritten seitlichen Führungsvorrichtungen 3c, 3c' angeordnet ist.

Der Abstand des Paars von ersten seitlichen Führungsvorrichtungen 3a, 3a' voneinander ist kleiner als der Abstand des Paars von zweiten seitlichen Führungsvorrichtungen 3b, 3b' voneinander, und der Abstand des Paars von zweiten seitlichen Führungsvorrichtungen 3b, 3b' voneinander ist kleiner ist als der Abstand des Paars von dritten seitlichen Führungsvorrichtungen 3c, 3c' voneinander. **In** Fig. 3 a) berühren die dritten seitlichen Führungsvorrichtungen 3c, 3c' den Wafer W nicht. Unterhalb des Wafers ist ein Keil 2 vorgesehen.

**In** Fig. 3b) werden die einzelnen Schritte genauer beschrieben.

**In** Schritt a) befindet sich der Wafer W unterhalb der Flüssigkeitsoberfläche des Bades 1 und wird vom ersten Paar von ersten seitlichen Führungsvorrichtungen 3a, 3a' sowie dem zweiten Paar von zweiten seitlichen Führungsvorrichtungen 3b, 3b' gehalten. Der Keil berührt den Wafer nicht. Das Paar von dritten seitlichen Führungsvorrichtungen 3c, 3c' berührt den Wafer W nicht.

in Schritt b) wird der Keil an den Wafer gefahren, so dass die Spitze des Keils den Wafer berührt.

In Schritt c) werden die seitlichen Führungsvorrichtungen 3a, 3a', 3b, 3b' und 3c, 3c' sowie der Keil 2 nach oben bewegt. Hier haben die dritten seitlichen Führungsvorrichtungen 3c, 3c' die Wasseroberfläche bereits passiert, haben allerdings keinen Kontakt zum Wafer W, d.h. berühren diesen nicht. Der Keil 2 bleibt an den Wafer W herangefahren und berührt diesen, allerdings noch unter der Wasseroberfläche.

In Schritt d) befindet sich der Wasserspiegel immer noch zwischen dem Paar von zweiten seitlichen Führungsvorrichtungen 3b, 3b' sowie dritten seitlichen Führungsvorrichtungen 3c, 3c'. Der Wafer W wird allerdings nur durch den Keil 2 etwas angehoben, so dass der Wafer das erste Paar von seitlichen Führungsvorrichtungen 3a, 3a' sowie das zweite Paar von seitlichen Führungsvorrichtungen 3b, 3b' nicht mehr berührt. Dafür ist der Wafer W in Kontakt mit dem dritten Paar von seitlichen Führungsvorrichtungen 3c, 3c' oberhalb der Flüssigkeitsoberfläche. Der Wafer wird somit nun vom Keil 2 sowie dem dritten Paar von seitlichen Führungsvorrichtungen 3c, 3c' gehalten.

In Schritt e) ist der Wafer W sowie die Spitze des Keils 2 sowie das erste Paar von seitlichen Führungsvorrichtungen 3a, 3a', das zweite Paar von seitlichen Führungsvorrichtungen 3b, 3b' sowie das dritte Paar von seitlichen Führungsvorrichtungen 3c, 3c' oberhalb der Wasseroberfläche.

In Schritt f) wird der Keil 2 abgesenkt, der Wafer wird wiederum vom Keil 2 sowie dem ersten Paar von seitlichen Führungsvorrichtungen 3a, 3a' sowie zweitem Paar von seitlichen Führungsvorrichtungen 3b, 3b', welche mittlerweile getrocknet sind, gehalten. Die dritten seitlichen Führungsvorrichtungen 3c, 3c' berühren den Wafer W nicht mehr.

In Schritt g) wurde der Wasserspiegel abgesenkt, die Position des Wafers W relativ zu den drei Führungsvorrichtungen 3a, 3a', 3b, 3b' sowie 3c, 3c' sowie des Keils 2 hat sich im Vergleich zu Schritt f) nicht verändert.

Bei einem Durchtritt durch die Flüssigkeitsoberfläche ist also nur ein Kontaktpunkt zwischen dem Wafer W und dem Keil 2 vorhanden, an welchem ein Resttropfen entstehen kann.

In Fig. 3c) ist ein Resttropfen unten am Kontaktpunkt des Keils 2 gezeigt, dieser muss allerdings nicht auftreten, und ist dann, wenn er auftritt, kleiner verglichen mit dem Verfahren gemäß Fig. 1 und Fig. 2.

Die Geschwindigkeit der Bewegung der seitlichen Führungsvorrichtungen 3a, 3a', 3b, 3b' und 3c, 3c' sowie dem Keil 2 sind jederzeit so aufeinander abgestimmt, dass die resultierende Verfahrgeschwindigkeit für die Wafer immer konstant ist und somit eingestellt werden kann. Der Verfahrweg der Wafer beim Ausheben ist im Vergleich von Fig. 1 deutlich geringer, dies führt zu einer kürzeren Prozesszeit. Es verkürzt sich als Folge auch die Kontaktzeit zwischen der Unterkante der Wafer W und dem mit Restfeuchte behafteten beweglichen Keil 2 um mehrere Minuten. Infolgedessen sinkt prinzipiell auch die Gefahr der Bildung von Resttropfen an den Kontaktstellen. Durch den verkürzten vertikalen Abstand zwischen Wafer und seitlichen Führungsvorrichtungen 3a, 3a', 3b, 3b' sowie 3c, 3c' können Wafer und seitliche Führungsvorrichtungen nahezu gleichzeitig getrocknet werden, dies verkürzt die Prozesszeit noch weiterhin.

Dies führt zu einer deutlich höheren Produktivität des gesamten Reinigungsprozesses, da die Trocknung in der Regel den langsamsten Prozessschritt darstellt und somit der limitierende Schritt für die Geschwindigkeit des ganzen Prozesses ist.

Der Justieraufwand für die Einrichtung und Korrektur der Position aller Komponenten (Keil sowie seitliche Führungsvorrichtungen) ist deutlich geringer, ein komplizierter Abgleich zwischen seitlichen Führungsvorrichtungen entfällt, und kein schräger Verfahrweg ist notwendig. Ferner besteht weniger Gefahr, dass der Wafer bei ungenauer Justierung unter mechanische Spannung gerät, was zu Kratzern auf den Wafern, Beschädigung der Waferkante sowie Waferbruch führen kann.

Die geringere Gefahr von Resttropfen und mechanischer Spannung für die Wafer durch eine ungenaue Justierung ist insbesondere für die Trocknung von größeren Wafern (beispielsweise über 150 mm) von großer Bedeutung, da die ungünstigen Hebelverhältnisse im Vergleich zu kleineren Waferdurchmessern einen deutlich höheren Justieraufwand und geringere Toleranzen erfordern würden, um eine gleichbleibende Waferqualität zu gewährleisten.

Die Kontaktzeit zwischen dem Keil 2 und dem Wafer W kann im Vergleich zu dem Verfahren in Fig. 1 von mehreren Minuten auf wenige Sekunden verkürzt werden, was dazu führt, dass die Wahrscheinlichkeit für die Entstehung von Resttropfen an der einzigen noch verbleibenden ersten Kontaktstelle (zwischen Keil 2 und Wafer W) deutlich gesenkt werden kann. Falls diese Resttropfen doch auftreten, sind sie wesentlich kleiner.

Vorzugsweise erfolgt das Ausheben der Wafer mit einer Geschwindigkeit von ca. 1mm/s. Für die Trocknung des unteren Abschnitts der Wafer (ca. 1 cm) wird die Aushebegeschwindigkeit zur Reduzierung der Kontakttropfen deutlich verringert, auf unter 0,5 mm/s.

Die Aushebegeschwindigkeit ist die Geschwindigkeit, mit welcher sich der Wafer relativ zum Flüssigkeitsspiegel bewegt.

Da zu starke Fluktuationen des Wasserspiegels in der chemischen Zusammensetzung der Oxidschicht abgebildet werden können, muss diese Geschwindigkeitsreduzierung schrittweise erfolgen.

Genau wenn die untere Kante des Wafers W den Wasserspiegel erreicht hat, müssen mit jeweils hoher Geschwindigkeit (> 30 mm/s, bevorzugt > 40 mm/s, weiter bevorzugt > 50 mm/s) die Wafer W vom Wasserspiegel und gleichzeitig in entgegengesetzter Richtung der Keil 2 von der Unterkante der Wafer W getrennt werden.

Insbesondere bei n-dotiertem GaAs ist auf Grund dessen hoher Oberflächenspannung eine präzise Einhaltung dieser Randbedingung erforderlich. Nur so kann verhindert werden, dass einerseits Wasser vom Wasserspiegel und andererseits Restfeuchte vom Keil 2 wieder auf die Oberfläche des Wafers gezogen werden.

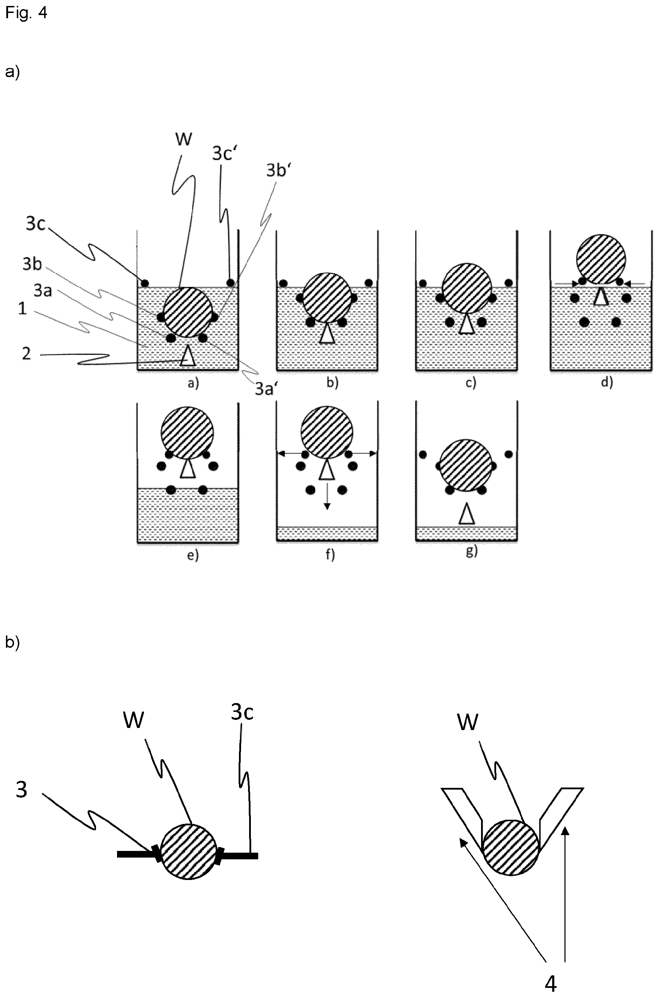

Fig. 4 zeigt eine weitere Ausführungsform eines Verfahrens zur Marangoni-Trocknung. Insbesondere wird in Fig. 4 a) die Abfolge der Verfahrensschritte gezeigt. In Schritt a) befindet sich der Wafer W unter der Flüssigkeitsoberfläche und wird von Paaren von ersten und zweiten seitlichen Führungsvorrichtungen 3a, 3a' sowie 3b, 3b' gehalten. Das Wasserbad 1 enthält Wasser, welches an seiner Oberfläche mit Isopropanol angereichert ist.

Ein paar von dritten seitlichen Führungsvorrichtungen 3c, 3c' ist oberhalb der Flüssigkeitsoberfläche. Diese fungieren sozusagen als Trockenübernehmer.

In Schritt b) wird der Wafer W durch einen Keil 2 etwas angehoben, ein Teil des Wafers ist über der Wasseroberfläche, der Keil 2 ist in Kontakt mit dem unteren Rand des Wafers W. Der Wafer wird unter der Wasseroberfläche immer noch von den seitlichen Führungsrichtungen 3a, 3a' und 3b, 3b' gehalten, welche sich aber etwas nach oben bewegt haben. Das Paar von dritten seitlichen Führungsvorrichtungen 3c, 3c' befindet sich noch über der Wasseroberfläche und ist nicht in Berührung mit dem Wafer.

Im Schritt c) bleibt die Position des Paars von ersten seitlichen Führungsvorrichtungen 3a, 3a' sowie des Paars von zweiten seitlichen Führungsvorrichtungen 3b, 3b' konstant, der Keil 2 hat allerdings den Wafer weiter angehoben, so dass dieser nur noch in Berührung mit dem Paar von zweiten seitlichen Führungsvorrichtungen 3b, 3b' ist, nicht aber mit dem Paar von ersten seitlichen Führungsvorrichtungen 3a, 3a' ist. Die Position des Paars von dritten seitlichen Führungsvorrichtungen 3c, 3c' hat sich im Vergleich zu Schritt b) nicht geändert.

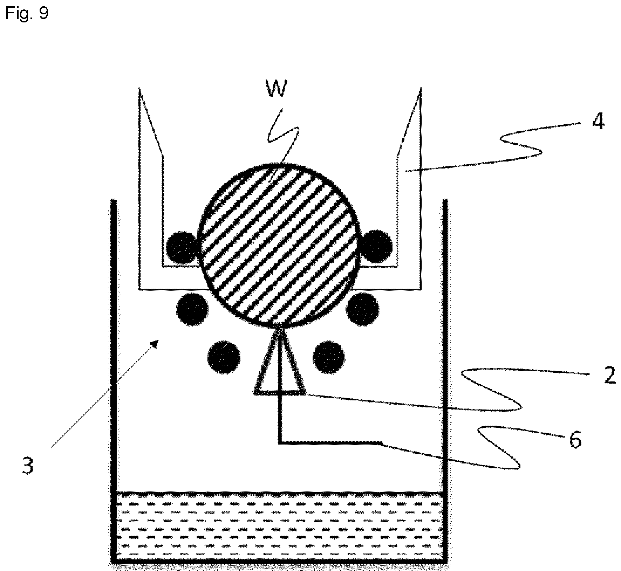

Im Schritt d) wurde der Wafer W komplett aus dem Flüssigkeitsbad ausgehoben. Der Keil 2 verbleibt allerdings unter der Flüssigkeitsoberfläche. Hierbei hat sich das Paar von dritten seitlichen Führungsvorrichtungen 3c, 3c' horizontal bewegt, der Abstand zwischen den dritten seitlichen Führungsvorrichtungen 3c, 3c' ist kleiner geworden. Entweder können die dritten seitlichen Führungsvorrichtungen 3c, 3c' eine Haltefunktion haben, oder eine zusätzliche Greifvorrichtung 4, wie in Fig. 9 dargestellt (nicht allerdings in der vorliegenden Figur), kann zum Einsatz kommen, um den Wafer W über der Flüssigkeitsoberfläche zu halten.

Diese halten den Wafer W über der Wasseroberfläche. In Schritt e) wird nun der Flüssigkeitsspiegel abgesenkt, indem Wasser abgelassen wird. In Schritt f) ändert sich an der Position der ersten und zweiten seitlichen Führungsvorrichtungen 3a, 3a', 3b, 3b' nichts, aber das Paar von dritten seitlichen Führungsvorrichtungen 3c, 3c' wird horizontal bewegt, der Abstand zwischen den dritten seitlichen Führungsvorrichtungen 3c, 3c' wird wieder größer, so dass der Wafer W nun wieder unter anderem auf dem Keil 2 aufliegt. Der Wafer W wird dann vom Keil 2 und den zweiten seitlichen Führungsvorrichtungen 3b, 3b' gehalten werden ab dem Moment ab dem die dritten seitlichen Führungsvorrichtungen 3c, 3c' den Wafer nicht mehr berühren. So sind sowohl der Keil 2 als auch sämtliche Führungsvorrichtungen 3a, 3a', 3b, 3b' sowie 3c, 3c' getrocknet. In Schritt g) wird der Keil 2 abgesenkt, so dass der Wafer W wieder von dem Paar von ersten seitlichen Führungsvorrichtungen 3a, 3a' sowie dem zweiten Paar von seitlichen Führungsvorrichtungen 3b, 3b' gehalten wird.

In diesem Verfahren ist die Besonderheit vorhanden, dass ein Durchdringen des Wafers durch den Wasserspiegel möglich ist, ohne einen einzigen Kontakt zu irgendeinem Werkzeug, das heißt weder zu einer der Führungsvorrichtungen 3a, 3a', 3b, 3b' sowie 3c, 3c', noch zum Keil 2. Der Keil 2 bleibt in allen Verfahrensschritten des Waferaushebens unter der Flüssigkeitsoberfläche, das Paar von dritten seitlichen Führungsvorrichtungen 3c, 3c' bleibt stets über der Flüssigkeitsoberfläche und wird so nie nass.

Fig. 4 b) zeigt, wie beispielsweise ab Schritt d) aus Fig. 4 a) der Wafer zusätzlich gehalten werden kann. Links sind die die dritten seitlichen Führungsvorrichtungen 3c, 3c' T- förmig dargestellt, das dazu führt, dass der Wafer W bessergehalten werden kann. In der rechten Ansicht sind Greifvorrichtungen 4 zu erkennen, welche den Wafer W über der Flüssigkeitsoberfläche zusätzlich halten können und auch hinsichtlich des Waferdurchmessers anpassbar sind.

Generell arbeiten die Ausführungsformen des erfindungsgemäßen Verfahrens (Fig, 3 und 4) mit einem Ablassen des Wassers im Prozessbecken erst dann, wenn sich der Wafer vollständig über der Flüssigkeitsoberfläche befindet. So kann immer ein Anströmen mit Reinstwasser (sogenannter Overflow) stattfinden. Die Oberfläche des Flüssigkeitsspiegels, auf der Partikel schwimmen können, ist somit immer gut durchströmt, und es findet Flüssigkeitsaustausch statt. Bei einem Verfahren gemäß Fig. 2 ist wird der Flüssigkeitsspiegel abgesenkt, während der Wafer W sich zumindest noch teilweise im Bad befindet. Ein Overflow an der Flüssigkeitsoberfläche ist dann nicht mehr möglich, dort können sich dann leicht Partikel akkumulieren, welche an den zu trocknenden Wafern W anhaften - dies verschlechtert dann Qualität der Epitaxieschicht.

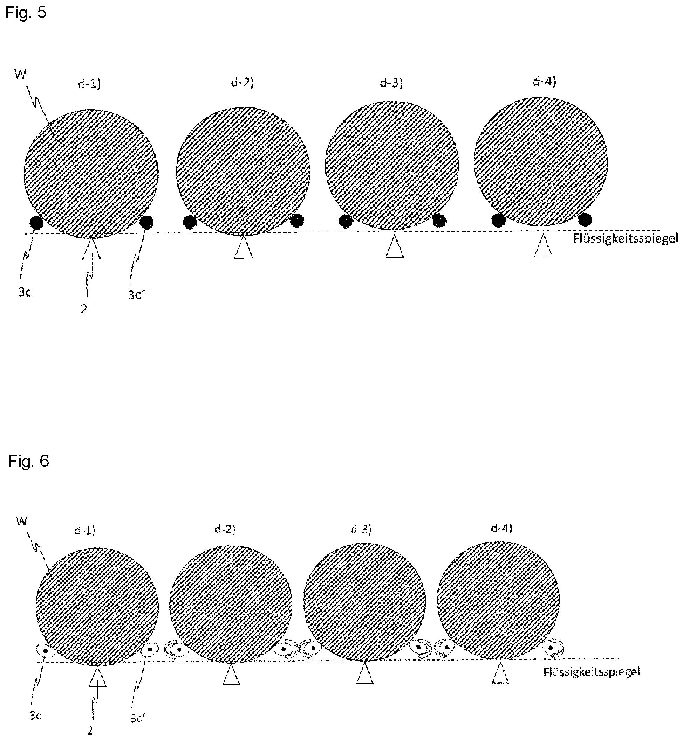

Fig. 5 zeigt eine genauere Darstellung der Abfolge des Schrittes d) aus Fig. 4 gemäß einer ersten Abwandlung - es werden sozusagen Unterschritte dargestellt. Hier ist in Schritt d-1) dargestellt, dass der Wafer W sich fast komplett oberhalb des Flüssigkeitsspiegels befindet, der Keil 2 befindet sich unterhalb des Flüssigkeitsspiegels, und das Paar von dritten seitlichen Führungsvorrichtungen 3c, 3c' befindet sich oberhalb des Flüssigkeitsspiegels und liegt am Wafer W an. In den Schritten d-2), d-3) und d-4) wird der Abstand des Paars von dritten seitlichen Führungsvorrichtungen 3c, 3c' immer weiter verringert, der Keil 2 bleibt allerdings stets unterhalb der Flüssigkeitsoberfläche. Im Schritt d-3) ist der gesamte Wafer bereits über der Wasseroberfläche, im Schritt d-4) hat sich der Wafer noch etwas nach oben bewegt. Die dritten seitlichen Führungsvorrichtungen 3c, 3c' sind somit Trockenübernehmer, diese sind immer oberhalb der Flüssigkeitsoberfläche und werden daher nie nass. Es ist lediglich eine horizontale Bewegung der dritten seitlichen Führungsvorrichtungen 3c, 3c' notwendig. Der Wafer rutscht auf den dritten seitlichen Führungsvorrichtungen 3c, 3c'.

Fig. 6 zeigt eine genauere Darstellung der Abfolge des Schrittes d) aus Fig. 4 gemäß einer zweiten Abwandlung - es werden sozusagen Unterschritte dargestellt. Hier ist lediglich die Struktur der dritten seitlichen Führungsvorrichtungen 3c, 3c' anders.

Diese sind hier oval ausgeführt, es ist zur Bewegung der Wafer W eine Horizontalbewegung und eine Drehbewegung notwendig. Auch hier wird nur das Ausheben der letzten Millimeter des gesamten Wafers W aus dem Flüssigkeitsbad, wie in Schritt d) in Fig. 4 dargestellt, entsprechend genauer ausgeführt. Im Schritt d-1) liegt der Wafer an zwei schräggestellten ovalen dritten seitlichen Führungsvorrichtungen 3c, 3c' an, die lange Seite der ovalen Form liegt an dem Wafer an. Der Wafer ist fast komplett aus dem Wasserbad ausgehoben, lediglich einen Millimeter taucht er noch ins Wasser ein. Der Keil 2 bleibt stets unter Wasser. Nun drehen sich in Schritt d-2) die ovalen dritten seitlichen Führungsvorrichtungen 3c, 3c', so dass der Wafer etwas weiter nach oben gedreht wird. In den Schritten d-3) und d-4) werden die dritten seitlichen Führungsvorrichtungen 3c, 3c' weitergedreht, bis der Wafer sich komplett oberhalb des Flüssigkeitsspiegels befindet.

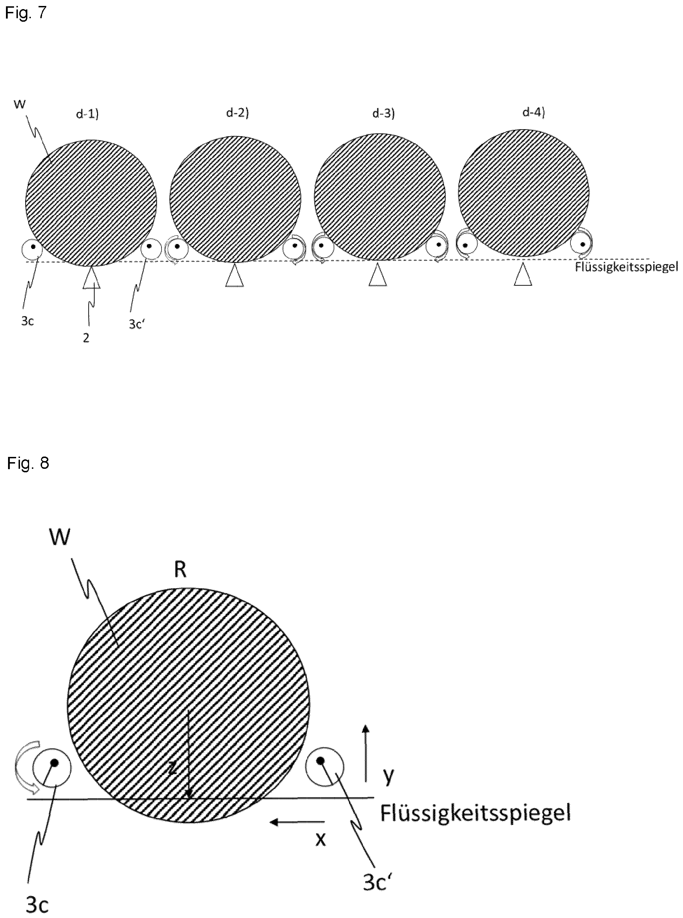

Fig. 7 zeigt eine genauere Darstellung der Abfolge des Schrittes d) aus Fig. 4 gemäß einer dritten Abwandlung - es werden sozusagen Unterschritte dargestellt. Hier haben die Trockenübernehmer, das heißt die dritten seitlichen Führungsvorrichtungen 3c, 3c' eine azentrische Achse, es ist eine Horizontalbewegung und eine Drehbewegung zum Bewegen der Wafer W nötig. Im Schritt d-1) ist der Wafer noch zu einem kleinen Teil unterhalb des Flüssigkeitsspiegels, im Schritt d-2) drehen sich die dritten seitlichen Führungsvorrichtungen 3c, 3c', weswegen der Wafer etwas nach oben gehoben wird, in Schritt d-3) haben sich die dritten seitlichen Führungsvorrichtungen 3c, 3c' weitergedreht, so dass der Wafer schon oberhalb des Flüssigkeitsspiegels ist, im Schritt d-4) ist er ein Stück über die Flüssigkeitsoberfläche gehoben. Der Keil 2 bleibt stets unter Wasser.

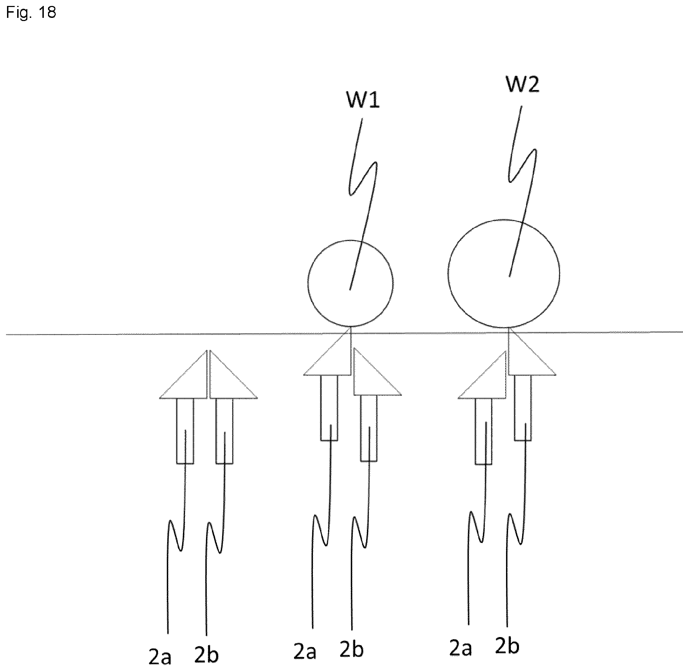

Fig. 8 zeigt eine Darstellung einer KI-unterstützten adaptiven Steuerung für das Wafer-Ausheben. Hier ist der Wafer W gezeigt, dieser hat einen Radius R, und ferner sind asymmetrisch das Paar von dritten seitlichen Führungsvorrichtungen 3c, 3c' gezeigt. Das Zusammenspiel der Bewegungen des Keils 2 (hier nicht dargestellt), der dritten seitlichen Führungsvorrichtungen 3c, 3c' und dem Wafer in Bezug auf die Position des Wasserspiegels ist komplex, insbesondere für das Trocknen unterschiedlicher Waferdurchmesser. Nach herkömmlichen Verfahren müssten komplexe Bewegungsabläufe erstellt werden, und die Mechanik müsste für jeden Durchmesser aufwendig kalibriert werden. Hier kann eine KI-unterstützte adaptive Steuerung eingesetzt werden. Wafer, welcher in einer Horde angeordnet sind, werden durch Kameras (hier nicht dargestellt) aufgenommen, und zwar mindestens der erste und der letzte Wafer einer Horde. Die Kameras sind fest über der Wasseroberfläche eingebaut, und die dritten seitlichen Führungsvorrichtungen 3c, 3c' sind farblich markiert, um die Bilderkennung zu erleichtern. Ein angelerntes neuronales Netzwerk mit KI-Bilderkennung kann dann den Waferdurchmesser sowie den Abstand zwischen Wafermittelpunkt und Wasserspiegel (Parameter z in Fig 18), die Position (Parameter x, y in Fig. 18), sowie eventuell die Drehposition der dritten seitlichen Führungsvorrichtungen 3c, 3c') ermitteln. Diese Daten können dann den Programmablauf steuern, insbesondere die Bewegung des Keils 2 in vertikaler Richtung, die Bewegung der dritten seitlichen Führungsvorrichtungen 3c, 3c' (Horizontalbewegung und eventuell Drehung), und noch andere wichtige Verfahrensparameter (beispielsweise Ablassen bzw. DI-Wasserzufluss) können entsprechend gesteuert werden. Die Beobachtung des ersten und letzten Wafers in einer Horde ermöglicht es, eine Verkippung der Hordenachse gegenüber der Ebene des Wasserspiegels zu erfassen, und notfalls entsprechende Gegenmaßnahmen zu veranlassen.

Fig. 9 zeigt eine weitere Ausführungsform einer entsprechenden Vorrichtung zum Trocknen von Wafern. Außer der Horde 3 und dem Keil 2 sind noch Greifvorrichtungen 4 vorgesehen, welche dazu eingerichtet sind, den Wafer, soweit sich der Wafer über die Wasseroberfläche erhebt, zu greifen. Sobald die Greifvorrichtungen 4 den Wafer gegriffen haben, kann der Keil 2, der sich noch unter Wasser befindet abgesenkt werden (in der Fig. nicht so dargestellt). Die Horde und der Greifer bewegen sich mit gleicher Geschwindigkeit nach oben und der Wafer tritt durch die Wasseroberfläche hindurch, ohne dass er an der Durchtrittsstelle von dem Keil 2 gehalten wird. Somit entsteht kein Resttropfen. Im Keil 2 ist hier eine Absaugvorrichtung 6 vorgesehen.

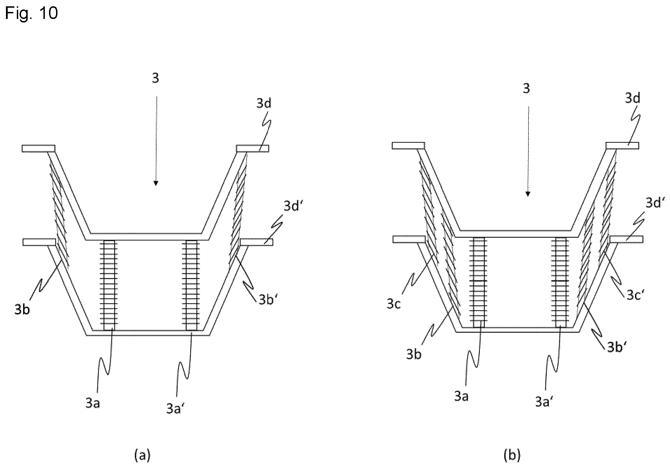

Fig. 10 zeigt zwei Horden - Fig. 10 a) zeigt eine Horde 3 gemäß dem Stand der Technik, welche beispielsweise bei einem Verfahren gemäß Fig. 1 zum Einsatz kommen kann. Hier sind zwei Kopfteile 3d, 3d' vorhanden, zwischen welchen zwei Paare von seitlichen Führungsvorrichtungen 3a, 3a' sowie 3b, 3b' angeordnet sind. Durch diese können die Wafer W (hier nicht dargestellt) gehalten werden. Die ersten seitlichen Führungsvorrichtungen 3a, 3a' sowie die zweiten seitlichen Fühungsvorrichtungen 3b, 3b' weisen jeweils Erhebungen (hier nicht im Detail dargestellt) auf - diese bilden eine kammartige Struktur, welche einzelne Wafer W (hier nicht dargestellt) halten kann - damit sich Wafer nicht gegenseitig berühren bzw. nicht kippen können.

Das Paar von ersten seitlichen Führungsvorrichtungen 3a, 3a' ist unterhalb des Paars von zweiten seitlichen Führungsvorrichtungen 3b, 3b' angeordnet.

Der Abstand des Paars von ersten seitlichen Führungsvorrichtungen 3a, 3a' voneinander ist kleiner als der Abstand des Paars von zweiten seitlichen Führungsvorrichtungen 3b, 3b' voneinander.

Fig. 10 b) zeigt eine Horde 3, welche bei einem erfindungsgemäßen Verfahren gemäß Fig. 3 zum Einsatz kommen kann.

Im Unterschied zu Fig. 4 a) ist hier oberhalb des Paars von zweiten seitlichen Führungsvorrichtungen 3b, 3b' ein Paar dritten seitlichen Führungsvorrichtungen 3c, 3c' angeordnet.

Der Abstand des Paars von ersten seitlichen Führungsvorrichtungen 3a, 3a' voneinander ist kleiner als der Abstand des Paars von zweiten seitlichen Führungsvorrichtungen 3b, 3b' voneinander, und der der Abstand des Paars von zweiten seitlichen Führungsvorrichtungen 3b, 3b' voneinander ist kleiner ist als der Abstand des Paars von dritten seitlichen Führungsvorrichtungen 3c, 3c' voneinander. Es bestehen so die Möglichkeit, einen Wafer W (hier nicht dargestellt) an mehreren Stellen im Vergleich zu Fig. 4 a) zu halten,

Die ersten seitlichen Führungsvorrichtungen 3a, 3a', die zweiten seitlichen Führungsvorrichtungen 3b, 3b' sowie die dritten seitlichen Führungsvorrichtungen 3c, 3c' weisen jeweils Erhebungen (hier nicht im Detail dargestellt) auf - diese bilden eine kammartige Struktur, welche einzelne Wafer W (hier nicht dargestellt) halten kann - damit sich Wafer nicht gegenseitig berühren bzw. nicht kippen können.

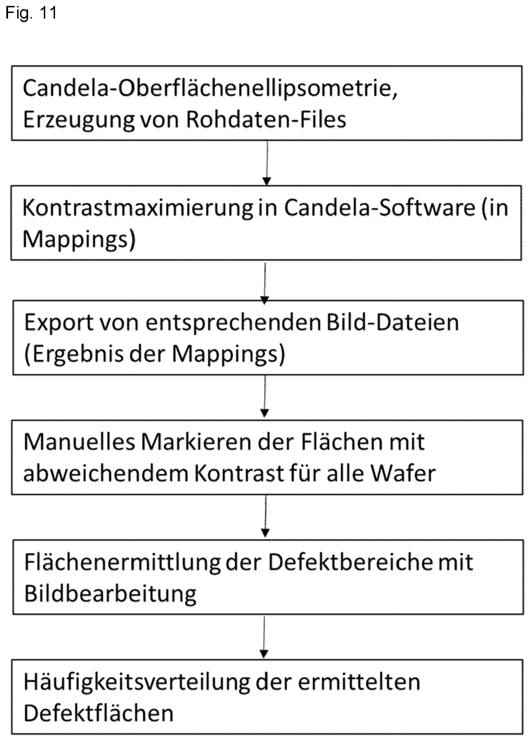

Fig. 11 zeigt eine entsprechende Auswerteroutine für Messungen, bei denen die Homogenität der Oberflächenoxidschicht erfindungsgemäßer Wafer vermessen werden kann: Mit dem Candela-Oberflächenellipsometer werden Rohdaten-Files erzeugt. Innerhalb der Software des Candela-Ellipsometers wird eine entsprechende Kontrastmaximierung vorgenommen, welche für das gesamte Mapping angewendet wird (der Kontrast wird - beispielsweise in einem Bildbearbeitungsprogramm für Pixelgrafiken - so lange variiert, bis Tropfenrückstände auf den dargestellten Bildern deutlich sichtbar sind; hier muss sichergestellt sein, dass sich ein Bereich mit tropfentypischer Form deutlich von seiner Umgebung abhebt).

Danach werden entsprechende Bilddateien exportiert. Dann erfolgt ein manuelles Markieren der Flächen mit einem abweichenden Kontrast für alle Wafer, wobei hier insbesondere auf die Randbereiche eingegangen wird.

An der Stelle, wo sich der Resttropfen wegen der Ausrichtung der Wafer beim Trocknungsprozess bilden kann, wurde zur Auswertung ein 9 cm breites und 1,9 cm hohes Viereck in den Wafer gelegt. Innerhalb dieses Vierecks wird der Tropfen identifiziert und ausgewertet. So kann sichergestellt werden, dass alle möglichen Resttropfen innerhalb eines 1 cm breiten Rings an der Außenkante des Wafers erfasst werden. Die Verwendung eines fiktiven Rechtecks ist sinnvoller und genauer, verglichen mit einem Ring (rundum laufender Streifen), der den Resttropfen in der Bildverarbeitung von einer möglichen Lasermarkierung auf der Wafervorderseite nicht leicht unterscheiden könnte.

Anschließend erfolgt eine Flächenermittlung der Defektbereiche mit Hilfe einer Bildverarbeitung, in welcher die Flächen entsprechend ausgemessen werden können. Diese misst die Fläche eines angegrenzten Bereichs.

Hier erfolgt typischerweise kein Randausschluss bestimmter Bereiche des Wafers - vielmehr kann der ganze Wafer weiterverwendet werden - da durch das verbesserte Marangoni-Trockungsverfahren entsprechende Defekte weitestgehend vermieden werden können.

Hier werden die Defekt-Flächen, welche Resttropfen bzw. deren Auswirkungen wie Veränderung der Oxidschichtzusammensetzung aufweisen, anhand folgender Kriterien ausgewählt, markiert und vermessen:
- Fläche muss am Rand des Wafers liegen
- Es liegt eine unregelmäßige Form vor
- Fläche hat eine abweichende Helligkeit von umliegenden Bereichen (in der Regel heller als umliegende Bereiche; kleinere dunklere Bereiche sind aber auch möglich)
- Die Form der Fläche ist typisch für einen Wasserrückstand (beispielsweise Tropfenform, Form mit runden / elliptischen / ovalen Elementen, langgestreckte und verzweigte Form).

Daraus ergibt sich eine Häufigkeitsverteilung der ermittelten Defektflächen.

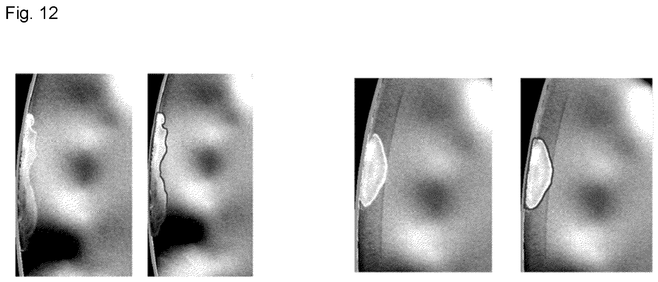

Fig. 12 zeigt zwei Beispiele von Tropfen am Rand der Wafer, welche jeweils markiert werden und deren Fläche gemessen wird. Es ist hier schwierig, eine automatisierte Auswertung vorzunehmen, da in den Wafern beispielsweise auch Kontrastvariationen durch andere Effekte (in Fig. 12 schwarz dargestellt) auftreten können, welche allerdings nicht mit dem Tropfen am Rand des Wafers verwechselt werden dürfen. Daher muss hier eine manuelle Auswertung erfolgen, bei der immer darauf geachtet wird, dass die Tropfen vom Rand des Wafers ausgehen, und eine entsprechende Form auch logisch der Form eines Tropfens zugeordnet werden kann. Eine komplett eckige Form kann also nicht einem Tropfen zugeordnet werden. Ebenfalls können beispielsweise Ränder mit feingliedrigen Zacken nicht einem Tropfen zugeordnet werden, da die Oberflächenspannung von Wasser die Ausbildung einer solchen Form nicht zulassen würde. Eine Form mit unregelmäßigen Randabschnitten ist aber möglich, wie sie in der linken Darstellung von Fig. 12 zu sehen ist.

Defekte entstehen durch Kontakte des Wafers mit Horde bzw. Keil beim Durchtritt durch die Flüssigkeitsoberfläche während der Trocknung durch anhaftende Tropfen, wodurch Flecken und damit "Defekte" verursacht werden können. Erfindungsgemäß blieben allerdings weniger Flecken, vorteilhaft nur ein einziger Flecken, und/oder eine insgesamt minimierte Fleckenfläche zurück, wohingegen bei Trocknungsverfahren gemäß dem Stand der Technik in der Regel mehrere und insgesamt größere Fleckenflächen zurückblieben.

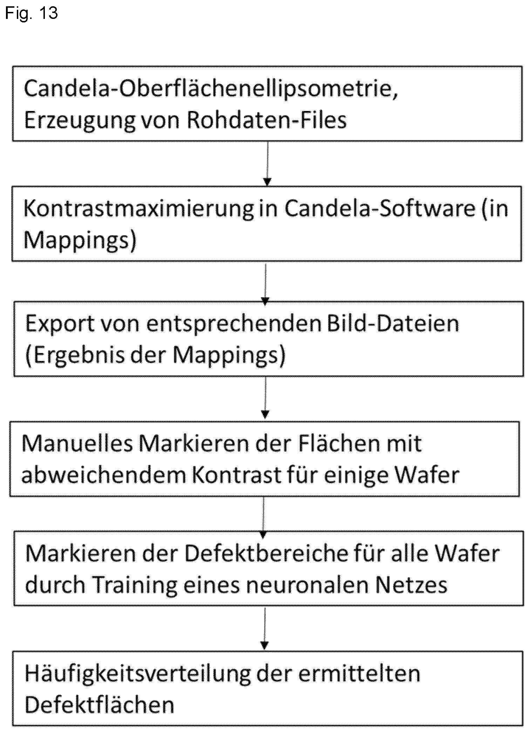

In Fig. 13 ist eine Alternative für die Auswerteroutine dargestellt, hier erfolgt nur eine manuelle Markierung der Flächen mit einem abweichenden Kontrast für einige Wafer, und mit Hilfe eines Trainierens eines neuronalen Netzes werden dann alle weiteren Wafer ausgewertet und die Defektbereiche werden hier entsprechend ausgewertet.

Da das Erscheinungsbild der Tropfenrückstände sehr unterschiedliche Kontraste aufweisen kann, wurde eine Segmentierung der Tropfenbereiche mit Hilfe eines neuronalen Netzes durchgeführt. Das neuronale Netz wurde in einer Tensorflow-Keras Umgebung trainiert. Als Model wurde eine UNet Struktur mit einem resnet34 backbone verwendet (U-Net: Convolutional Networks for Biomedical Image Segmentation", Olaf Ronneberger, Philipp Fischer, Thomas Brox, arXiv 2015, https://doi.org/10.48550/arxiv.1505.04597 ; http://lmb.informatik.uni-freiburg.de/people/ronneber/u-net).

Die segmentierten Bereiche wurden für alle Bilder visuell auf Plausibilität geprüft und gegebenenfalls in den Trainingsdatensatz für ein erneutes Anlernen des Netzes mit aufgenommen. Dieses Vorgehen wurde iterativ so lange durchgeführt, bis für mehr als 98% aller Bilder die automatische Segmentierung mit der visuellen Einschätzung übereinstimmte. Die auf diese Weise segmentierten Bereiche werden danach in einem zweiten Schritt durch klassische Bildverarbeitung (z.B. OpenCV: https://opencv.org/ ) automatisch selektiert und in ihrer flächenhaften Ausdehnung vermessen.

Die Kontraste werden also nicht durch Schwellwerte, sondern durch ihre Ausprägung visuell bzw. durch einen angelernten Algorithmus bzw. durch ein neuronales Netz ausgewertet; hier wird nicht auf den Absolutbetrag des Messignals gesehen, sondern nur auf die Erkennbarkeit von Tropfenbereichen. Diese Auswertung erfolgt außerhalb des Candela-Ellipsometers.

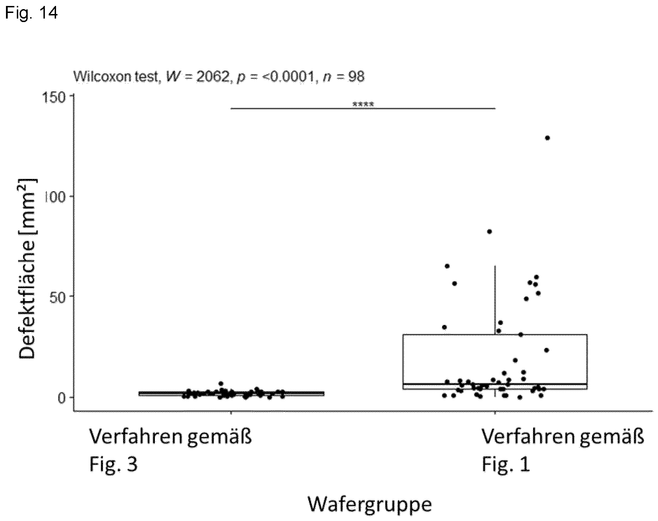

Fig. 14 zeigt ein Ergebnis der Messung der Defektflächen von zwei entsprechenden Wafergruppen halbisolierender, undotierter GaAs-Wafer mit 150 mm Durchmesser, rechts von Wafern, die mit einer herkömmlichen Marangoni-Trocknung (gemäß dem Verfahren in Fig. 1) getrocknet wurden, und links Wafer, die mit einer verbesserten Marangoni-Trocknung gemäß dem erfindungsgemäßen Verfahren (Fig. 3) getrocknet wurden. Für undotierte Wafer konnte gezeigt werden, dass die Streuung unterschiedlicher Defektflächen der nach dem neuen Verfahren hergestellten Wafer wesentlich geringer ist, und dass die absolute Defektfläche deutlich geringer ist (unter 5 mm²).

Die Defektfläche entspricht der Fläche, welche durch die Oberflächenmessung mithilfe der Candela-Ellipsometrie gemessen wurde. Chemisch gesehen ist hier eine inhomogene Zusammensetzung des Oberflächenoxids vorhanden - Defektflächen sind also Bereiche des Oberflächenoxids, in welchen die Oxidzusammensetzung inhomogen ist.

Da die Tropfengröße in den Daten deutlich nichtnormalverteilt ist, lässt sich ein normaler t-Test nicht durchführen. In diesen Fällen eignet sich der Wilcoxon Test, der keine Annahmen über die zugrundeliegenden Verteilungen voraussetzt. In diesem Test werden Rangsummen der betrachteten Werte gebildet, die wiederum näherungsweise normalverteilt sind und eine statistische Aussage zulassen. Da die Tropfengrößen beider Methoden deutlich unterschiedlich sind, wurde ein einseitiger Test mit einem Konfidenzniveau von 0.95 durchgeführt. Mit dem Parameter n wird die Gesamtanzahl der Werte angegeben, wenn der p-Wert dieser unterhalb eines typischen Wertes von 0.05, so kann die Nullhypothese (in diesem Fall: die Tropfengrößen erhalten mit dem Verfahren gemäß Fig. 3 sind größer als die Tropfengrößen erhalten mit der Verfahren nach Fig. 1) verworfen werden. Die sehr kleinen p-Werte (< 0,0001) der Daten zeigen also sehr signifikant, dass die Tropfengrößen, welche mit dem Verfahren nach Fig. 3 erhalten werden, kleiner sind. Mit dem Parameter W ist Rangsumme einer der beiden Gruppen gemeint.

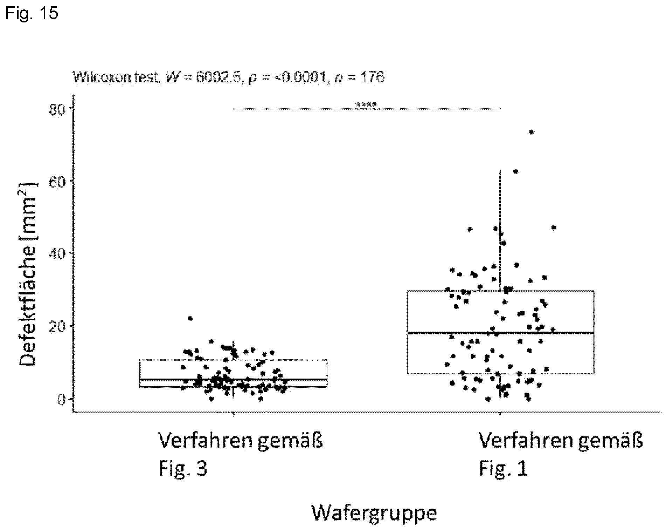

Fig. 15 zeigt ein Ergebnis der Messung der Defektflächen von zwei entsprechenden Wafergruppen halbleitender, Silizium-dotierter GaAs-Wafer mit 150 mm Durchmesser, rechts von Wafern, die mit einer herkömmlichen Marangoni-Trocknung (gemäß dem Verfahren in Fig. 1) getrocknet wurden, und links von Wafern, die mit einer erfindungsgemäßen verbesserten Marangoni-Trocknung nach Fig. 3 getrocknet wurden. Auch für Si-dotierte Wafer konnte gezeigt werden, dass die Streuung mit dem erfindungsgemäßen Verfahren wesentlich geringer ist und die Defektfläche (unter 25 mm²) deutlich geringer ist.

Da die Tropfengröße in den Daten deutlich nichtnormalverteilt ist, lässt sich ein normaler t-Test nicht durchführen. In diesen Fällen eignet sich der Wilcoxon Test, der keine Annahmen über die zugrundeliegenden Verteilungen voraussetzt. In diesem Test werden Rangsummen der betrachteten Werte gebildet, die wiederum näherungsweise normalverteilt sind und eine statistische Aussage zulassen. Da die Tropfengrößen beider Methoden deutlich unterschiedlich sind, wurde ein einseitiger Test mit einem Konfidenzniveau von 0.95 durchgeführt. Mit dem Parameter n wird die Gesamtanzahl der Werte angegeben, wenn der p-Wert dieser unterhalb eines typischen Wertes von 0.05, so kann die Nullhypothese (in diesem Fall: die Tropfengrößen erhalten mit dem Verfahren gemäß Fig. 3 sind größer als die Tropfengrößen erhalten mit der Verfahren nach Fig. 1) verworfen werden. Die sehr kleinen p-Werte (< 0,0001) der Daten zeigen also sehr signifikant, dass die Tropfengrößen, welche mit dem Verfahren nach Fig. 3 erhalten werden, kleiner sind. Mit dem Parameter W ist Rangsumme einer der beiden Gruppen gemeint.

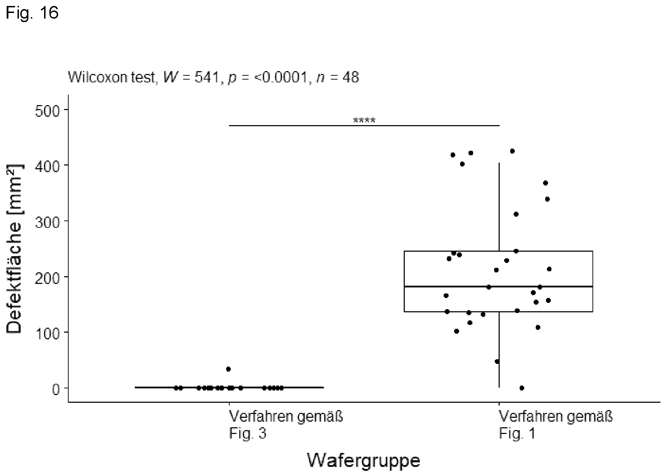

Fig. 16 zeigt ein Ergebnis der Messung der Defektflächen von zwei entsprechenden Wafergruppen aus halbleitenden, mit Schwefel-dotierten InP-Wafern mit 100 mm Durchmesser, rechts von Wafern, die mit einer herkömmlichen Marangoni-Trocknung (gemäß dem Verfahren in Fig. 1) getrocknet wurden, und links von Wafern, die mit einer verbesserten Marangoni-Trocknung gemäß dem erfindungsgemäßen Verfahren (Fig. 3) getrocknet wurden. Für Schwefel-dotierte Wafer konnte gezeigt werden, dass die Streuung unterschiedlicher Defektflächen der nach dem neuen Verfahren hergestellten Wafer wesentlich geringer ist, und dass die absolute Defektfläche deutlich geringer ist (unter 5 mm²).

Die Defektfläche entspricht der Fläche, welche durch die Oberflächenmessung mithilfe der Candela-Ellipsometrie gemessen wurde. Chemisch gesehen ist hier eine inhomogene Zusammensetzung des Oberflächenoxids vorhanden - Defektflächen sind also Bereiche des Oberflächenoxids, in welchen die Oxidzusammensetzung inhomogen ist.

Da die Tropfengröße in den Daten deutlich nichtnormalverteilt ist, lässt sich ein normaler t-Test nicht durchführen. In diesen Fällen eignet sich der Wilcoxon Test, der keine Annahmen über die zugrundeliegenden Verteilungen voraussetzt. In diesem Test werden Rangsummen der betrachteten Werte gebildet, die wiederum näherungsweise normalverteilt sind und eine statistische Aussage zulassen. Da die Tropfengrößen beider Methoden deutlich unterschiedlich sind, wurde ein einseitiger Test mit einem Konfidenzniveau von 0.95 durchgeführt. Mit dem Parameter n wird die Gesamtanzahl der Werte angegeben, wenn der p-Wert dieser unterhalb eines typischen Wertes von 0.05, so kann die Nullhypothese (in diesem Fall: die Tropfengrößen erhalten mit dem Verfahren gemäß Fig. 3 sind größer als die Tropfengrößen erhalten mit der Verfahren nach Fig. 1) verworfen werden. Die sehr kleinen p-Werte (< 0,0001) der Daten zeigen also sehr signifikant, dass die Tropfengrößen, welche mit dem Verfahren nach Fig. 3 erhalten werden, kleiner sind. Mit dem Parameter W ist Rangsumme einer der beiden Gruppen gemeint.

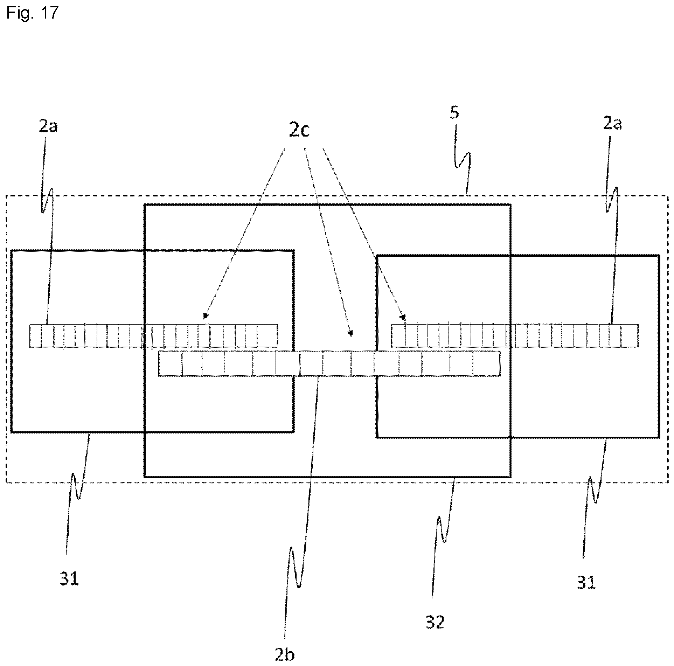

In Fig. 17 ist eine Ausführungsform einer erfindungsgemäßen Vorrichtung zum Trocknen von Wafern gezeigt. Hier ist eine Lagervorrichtung 5 vorhanden, in diese können verschiedene Horden 3, 31, 32 eingehängt werden.

Die Horden selbst halten die Wafer mit Führungsvorrichtungen (Kammstäbe). In der vorliegenden Ansicht sind hier entweder zwei erste Horden 31 einhängbar, oder eine zweite Horde 32. Eine erste Horde 31 dient zum Trocknen von Wafern mit kleinem Durchmesser verglichen mit der Horde 32. Der Keil besteht hier aus zwei ersten Keilabschnitten 2a und aus einem zweiten Keilabschnitt 2b, diese sind getrennt voneinander vertikal verfahrbar. Die Mitten der ersten Horden 31 sind direkt über der Spitze der ersten Keilabschnitte 2a positioniert, und die Mitte der zweiten Horde 32 ist oberhalb der Spitze des zweiten Keilabschnitts 2b positioniert. Auch der erste Keilabschnitt 2a und der zweite Keilabschnitt 2b haben entsprechende Erhebungen 2c, welche eine kammartige Struktur ausbilden.

Die zweite Horde 32 ist für größere Wafer, beispielsweise mit einem Durchmesser von größer oder gleich 200 mm, vorgesehen, und die Erhebungen 2c haben einen größeren Abstand verglichen mit den ersten Horden 31; somit sind die Horden 32 länger als die ersten Horden 31 und die Wafer können nicht mehr mit gleichen Keilen ausgehoben werden wie Wafer mit kleinen Durchmessern. Die Keilabschnitte 2a, 2b müssen immer mittig zu den Horden angebracht werden, da sie die Wafer in einem unteren Punkt erfassen müssen. Das Ausheben von beispielsweise Wafern mit einem Durchmesser bis 150 mm einerseits und größer oder gleich 200 mm Wafern andererseits in einem Trockner ist daher gemäß dem Stand der Technik nicht möglich. In der erfindungsgemäßen Vorrichtung wird daher für kleinere Wafer (z.B. Durchmesser von 150 mm oder kleiner) und größere (z.B. Durchmesser von 200 mm oder größer) Wafer jeweils ein eigener Keilabschnitt (2a für kleinere Wafer W1, 2b für größere Wafer W2) verwendet, mit einer entsprechend geeigneten Länge und jeweils angepassten Abständen von den Erhebungen 2c. Da die 200 mm-Wafer einen größeren Durchmesser haben, muss der Abstand der Erhebungen 2c größer als bei kleineren Waferdurchmessern sein, damit Wafer W2, wenn sie leicht kippen, sich gegenseitig nicht berühren.

Fig. 18 zeigt eine seitliche Ansicht der Keile 2 einer erfindungsgemäßen Vorrichtung. Hier wird in der linken Ansicht die Struktur eines ersten Keilabschnitts 2a und eines zweiten Keilabschnitts 2b gezeigt.

In der mittleren Ansicht wird gezeigt, dass ein Wafer mit kleinem Durchmesser W1 (beispielsweise ein 3 Zoll- oder ein 150 mm Wafer) hier mit dem ersten Keilabschnitt 2a nach oben gehoben wird. In der rechten Ansicht wird gezeigt, dass ein größerer Wafer mit größerem Durchmesser W2 (beispielsweise ein 200 mm Wafer) mit Hilfe des zweiten Keilabschnitts nach oben gehoben wird.

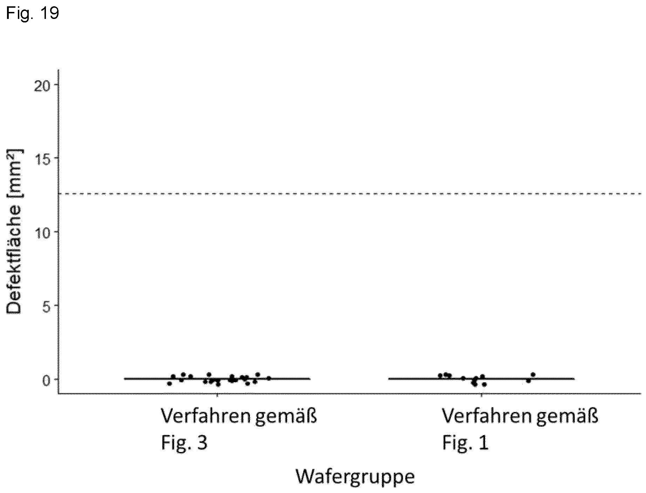

Fig. 19 zeigt ein Ergebnis der Messung der Defektflächen von zwei entsprechenden Wafergruppen halbisolierender, Fe-dotierter InP-Wafer mit 150 mm Durchmesser, rechts von Wafern, die mit einer herkömmlichen Marangoni-Trocknung (gemäß dem Verfahren in Fig. 1) getrocknet wurden, und links Wafer, die mit einer verbesserten Marangoni-Trocknung gemäß dem erfindungsgemäßen Verfahren (Fig. 3) getrocknet wurden. Für die Fe-dotierten Wafer konnte gezeigt werden, dass die Streuung unterschiedlicher Defektflächen der nach dem bisherigen und dem neuen Verfahren hergestellten Wafer ähnlich gering ist, es ist fast keine Defektfläche zu sehen.

Die Defektfläche entspricht der Fläche, welche durch die Oberflächenmessung mithilfe der Candela-Ellipsometrie gemessen wurde.

Ein erfindungsgemäßes Verfahren zum Trocknen eines Wafers enthält ein Bad mit einer Anordnung von mindestens einem Keil sowie mindestens einer Horde. Eine Horde weist Folgendes auf:
Ein Paar von ersten seitlichen Führungsvorrichtungen 3a, 3a', ein Paar von zweiten seitlichen Führungsvorrichtungen 3b, 3b' sowie ein Paar von dritten seitlichen Führungsvorrichtungen 3c, 3c'.

Das Paar von ersten seitlichen Führungsvorrichtungen 3a, 3a' ist unterhalb des Paars von zweiten seitlichen Führungsvorrichtungen 3b, 3b' angeordnet, und das Paar von zweiten seitlichen Führungsvorrichtungen 3b, 3b' ist unterhalb des Paars von dritten seitlichen Führungsvorrichtungen 3c, 3c' angeordnet.

Der Abstand des Paars von ersten seitlichen Führungsvorrichtungen 3a, 3a' voneinander ist vorzugsweise kleiner als der Abstand des Paars von zweiten seitlichen Führungsvorrichtungen 3b, 3b' voneinander, und der der Abstand des Paars von zweiten seitlichen Führungsvorrichtungen 3b, 3b' voneinander ist kleiner ist als der Abstand des Paars von dritten seitlichen Führungsvorrichtungen 3c, 3c' voneinander.

Das erfindungsgemäße Verfahren umfasst die folgenden Schritte:
i) Vertikales Bewegen des mindestens einen Keils 2 nach oben, bis dieser den Wafer an dessen unterstem Punkt berührt, vertikales Bewegen des Paars von ersten seitlichen Führungsvorrichtungen 3a, 3a' und des Paars von zweiten seitlichen Führungsvorrichtungen 3b, 3b' nach oben,
   wobei der Wafer W das Paar von ersten seitlichen Führungsvorrichtungen 3a und das Paar von zweiten seitlichen Führungsvorrichtungen 3b berührt, wobei ein oberer Bereich des Wafers W aus dem Bad 1 hinausgeschoben werden, wobei das Paar von dritten seitlichen Führungsvorrichtung 3c den Wafer nicht berührt;
ii) Vertikales Bewegen des Keils 2 nach oben, bis das Paar von ersten seitlichen Führungsvorrichtungen 3a, 3a' sowie das Paar von zweiten seitlichen Führungsvorrichtungen 3b, 3b' den Wafer W nicht mehr berühren, während sie sich noch unter der Flüssigkeitsoberfläche des Bades 1 befinden, wobei das Paar von dritten seitlichen Führungsvorrichtungen 3c, 3c' den Wafer oberhalb der Flüssigkeitsoberfläche des Bades 1 berühren;
iii) Herausschieben des Wafers W oberhalb des Flüssigkeitsspiegels des Bads 1, wobei das Paar von dritten seitlichen Führungsvorrichtungen 3c, 3c' den Wafer W berührt.

Verglichen mit dem Stand der Technik (siehe Fig. 1) erfolgt das Halten der Wafer nicht mehr durch die fixen und auf einen Waferdurchmesser begrenzten Halterungen H und H', beispielsweise also im Deckel des Trockners, sondern insbesondere durch das Paar von dritten seitlichen Führungsvorrichtungen 3c, 3c'

Somit wird ein Kontakt der Wafer mit insbesondere den ersten und zweiten seitlichen Führungsvorrichtungen 3a, 3a', 3b, 3b' der Horde 3, 31, 32 vermieden, während der Wasserspiegel die genannten ersten und zweiten seitlichen Führungsvorrichtungen entsprechend passiert. Die Wafer W, W1, W2 werden durch die dritten seitlichen Führungsvorrichtungen 3c, 3c', welche sich oberhalb des Wasserspiegels befinden und bereits getrocknet sind, gehalten. Der vertikale Verfahrweg der Wafer beim erfindungsgemäßen Trocknen ist wesentlich kürzer und kann auf wenige Sekunden beschränkt werden. Tropfen, die beim Kontakt zwischen Wafer und Keil 2, 2a ,2b entstehen sollten, treten dadurch deutlich seltener auf und sind auch kleiner. Bei einer Candela-Messung von getrockneten Wafern nach diesem Verfahren zeigen sich weniger und kleinere Resttropfen.

Vorzugsweise weist das erfindungsgemäße Verfahren weiterhin die folgenden Schritte auf:
iv) Vertikales Bewegen eines Keils 2 nach unten, bis der Wafer W mindestens eine des Paars von ersten seitlichen Führungsvorrichtungen 3a und des Paars von zweiten seitlichen Führungsvorrichtungen 3b berührt;
v) Weiteres vertikales Bewegen eines Keils 2 nach unten, bis dieser den Wafer W nicht mehr berührt;
wobei parallel zu den Schritten iv) und/oder v) oder nach dem Schritt v) der Flüssigkeitsspiegels des Bads 1 abgesenkt wird, bis der Flüssigkeitsspiegel sich unterhalb des Keils 2 befindet.

So können auch die Führungsvorrichtungen 3a, 3a', 3b, 3b' bzw. die Horde 3, 31, 32 und der Keil 2, 2a, 2b getrocknet werden, bis diese bereit für einen nächsten Trocknungseinsatz von Wafern sind.

Vorzugsweise enthält das Bad 1 Wasser und mindestens eine weitere oberflächenspannungsreduzierende Substanz, vorzugsweise Isopropanol.

So kann erreicht werden, dass der Marangoni-Effekt im erfindungsgemäßen Verfahren optimal eingesetzt werden kann.

Vorzugsweise besteht das Paar von ersten seitlichen Führungsvorrichtungen 3a, 3a', das Paar von zweiten seitlichen Führungsvorrichtungen 3b, 3b' und/oder das Paar von dritten seitlichen Führungsvorrichtungen 3c, 3c' jeweils aus einem Paar Stegen, die dazu angepasst sind, gegenüberliegende Seiten des Wafers W, W1, W2 bei unterschiedlichen Verfahrensschritten zu berühren. So kann sichergestellt werden, dass die Wafer W, W1, W2 seitlich gehalten werden, und sich während des Trocknungsvorgangs nicht berühren, (d.h. im Trockner auch nicht umkippen können) Sich während der Trocknung berührende Wafer könnten nämlich sonst aneinander "kleben" und so eine Trocknung verhindern, d.h. die Wafer würden dann nass bleiben.

Vorzugsweise ist in Schritt i) das Paar von ersten seitlichen Führungsvorrichtungen 3a, 3a' sowie das Paar von zweiten seitlichen Führungsvorrichtungen 3b, 3b' im Bad 1 eingetaucht, und vorzugsweise berührt am Ende des Schritts v) das Paar von dritten seitlichen Führungsvorrichtungen 3c, 3c' den Wafer W, W1, W2 nicht.

Dadurch, dass beim Durchtritt durch die Flüssigkeitsoberfläche des Bades nur maximal der Kontakt zwischen Keil und Wafer besteht (oder sogar gar kein Kontakt des Wafers zu irgendeiner Führungsvorrichtung oder dem Keil besteht), kann sichergestellt werden, dass im Bereich der ersten, zweiten und dritten Führungsvorrichtungen keine Resttropfen am Wafer W, W1, W2 anhaften, welche die Oberflächenhomogenität der Waferoberfläche entsprechend verschlechtern könnten.

Vorzugsweise ist der Keil 2, 2a, 2b mit mindestens einer Absaugvorrichtung 6 versehen, an welcher ein Unterdruck anlegbar ist, wenn sich die obere Spitze des Keils 2, 2a, 2b oberhalb des Flüssigkeitsspiegels befindet. So kann sichergestellt werden, dass das an den Spitzen des Keils 2, 2a, 2b verbleibende Wasser abgesaugt wird, so dass der Tropfen nicht auf den Wafer W, W1, W2 gelangt und so entsprechend eine Inhomogenität in der Oxidoberfläche hervorrufen könnte.

Vorzugsweise weist der Keil 2, 2a, 2b eine oberflächenspannungserhöhende Oberflächenstruktur auf, beispielsweise durch eine Plasmabehandlung von PEEK, aus welchem ein Keil 2, 2a, 2b gefertigt sein kann. Eine erhöhte Oberflächenspannung des Keils 2, 2a, 2b kann dazu führen, dass der Resttropfen am Keil 2, 2a, 2b verbleibt und nicht auf den Wafer W, W1, W2 übergeht.

Vorzugsweise ist die Aushebegeschwindigkeit abhängig von der Position des untersten Punkts des Wafers und beträgt zwischen 0,8 und 1,2 mm/s, wenn der unterste Punkt des Wafers mehr als 1,2 cm unter dem Flüssigkeitsspiegel liegt, und beträgt zwischen 0,4 und 0,5 mm/s, wenn der unterste Punkt des Wafers weniger als 1,2 cm unter dem Flüssigkeitsspeigel liegt, was zu einer deutlichen Reduzierung der Kontakttropfen führt. Da zu starke Fluktuationen des Wasserspiegels
in der chemischen Zusammensetzung der Oxidschicht abgebildet werden können, sollte diese Geschwindigkeitsreduzierung schrittweise erfolgen. Die Aushebegeschwindigkeit beträgt mindestens 30 mm/s (vorzugsweise 40 mm/s oder 50 mm/s), sobald der unterste Punkt des Wafers W den Flüssigkeitsspiegel erreicht hat. So kann verhindert werden, dass einerseits Wasser vom Wasserspiegel und andererseits Restfeuchte vom Keil wieder auf die Waferoberfläche gezogen werden. Gleichzeitig kann in entgegengesetzter Richtung der Keil von der Unterkante der Wafer getrennt werden.

Gemäß einer Ausführungsform ist das Paar von ersten seitlichen Führungsvorrichtungen 3a, 3a', das Paar von zweiten seitlichen Führungsvorrichtungen 3b, 3b' sowie das Paar von dritten seitlichen Führungsvorrichtungen 3c, 3c' an einer Horde 3 vorgesehen ist, und in Schritt i) wird die gesamte Horde 3 bewegt, in Schritt iii) wird der Wafer W oberhalb den Flüssigkeitsspiegels des Bads 1 herausgeschoben, wobei das Paar von dritten seitlichen Führungsvorrichtungen 3c, 3c' (bereits oberhalb des Flüssigkeitsspeigels) und der Keil 2 den Wafer W berühren. Beim Durchtritt durch den Flüssigkeitsspiegel besteht also nur ein Kontaktpunkt zwischen Keil und Wafer - die Tropfenfläche kann minimiert werden.

Gemäß einer anderen Ausführungsform ist das Paar von dritten seitlichen Führungsvorrichtungen 3c, 3c' in allen Verfahrensschritten oberhalb des Flüssigkeitsspiegels positioniert und unabhängig von dem Paar von ersten seitlichen Führungsvorrichtungen 3a, 3a' und dem Paar von zweiten seitlichen Führungsvorrichtungen 3b, 3b' beweglich, und die dritten seitlichen Führungsvorrichtungen 3c, 3c' sind relativ zueinander horizontal beweglich. Somit bleiben die dritten seitlichen Führungsvorrichtungen 3c, 3c' stets trocken, und können den Wafer W oberhalb des Flüssigkeitsspiegels greifen. Beim Durchtritt durch den Flüssigkeitsspiegel besteht also gar kein Kontaktpunkt zwischen Keil und Wafer - die Tropfenfläche kann dann sogar komplett vermieden werden.

Vorzugsweise bleibt dann der Keil 2 in allen Verfahrensschritten unterhalb des Flüssigkeitsspiegels. Dies ist der Grund, warum im Bereich des Keils kein Resttropfen mehr am Wafer verbleibt.

Vorzugsweise wird in Schritt iii) der Abstand der Punkte, an denen die dritten seitlichen Führungsvorrichtungen 3c, 3c' den Wafer berühren, stetig verringert. So kann der Wafer W durch Horizontalbewegung der dritten seitlichen Führungsvorrichtungen 3c, 3c' vertikal bewegt werden. Die dritten seitlichen Führungsvorrichtungen 3c, 3c' sind weiter vorzugsweise dazu angepasst, eine horizontale Bewegung relativ zueinander auszuführen.

Weiter vorzugsweise sind die dritten seitlichen Führungsvorrichtungen 3c, 3c' entweder azentrisch gelagert sind oder weisen eine ovale Form auf und sind dazu angepasst sind, eine Drehbewegung auszuführen. So kann durch Drehbewegung der dritten seitlichen Führungsvorrichtungen 3c, 3c' eine vertikale Bewegung des Wafers hervorgerufen werden, und kann in dem Bereich hilfreich sein, in welchem das letzte Stück des Wafers aus dem Bad ausgehoben wird - in diesem Moment wird der Keil 2 nicht für die vertikale Bewegung des Wafers benötigt, wodurch ein Kontaktpunkt Wafer W - Keil 2 beim Durchtritt durch den Flüssigkeitsspiegel vermieden werden kann.

Weitere Verfahrensparameter können Einfluss auf die Homogenität der Oxidoberfläche eines III-V-Wafers haben:
- Als ein weiterer zu kontrollierender Parameter für die Resttropfen-freie Marangoni Trocknung erwies sich die Konzentration der die Oberflächenspannung des Reinstwassers erniedrigenden Substanz, vorzugsweise Isopropylalkohol (IPA). Eine Verringerung der IPA-Zufuhr in der letzten Phase der Trocknung führt zu einem stärkeren vertikalen Gradienten in der Oberflächenspannung und bewirkt eine Verringerung der Gefahr der Bildung von Resttropfen. Aufgrund der verzögerten Wirkung einer Reduktion der IPA-Zufuhr auf die IPA-Konzentration im Gasraum und nachfolgend auf das Ausmaß des Konzentrationsgradienten kann es sinnvoll sein, die IPA-Zufuhr bereits schrittweise abzusenken, nachdem die Phasengrenzfläche (Flüssigkeitsoberfläche) das Waferzentrum passiert hat.
   Insbesondere für n-dotiertes GaAs kann eine stärkere Reduzierung der IPA-Zufuhr sinnvoll sein.
- Der IPA-Gradient an der Grenzfläche ergibt sich durch das Zusammenspiel zwischen der eingestellten IPA-Zufuhr und dem gegenläufig wirkenden Overflow mit deionisiertem Wasser (Reinstwasser) im Prozessbecken. Gleichzeitig hat die Stärke des Overflows einen Einfluss auf die an den Wafern haftenbleibenden Partikel. Wafer aus Indiumphosphid weisen bei gleicher Vorbehandlung eine höhere Oberflächenspannung und ein deutlich höheres Haftungsvermögen für Partikel auf als GaAs. Für ein niedrigeres Niveau an Restpartikeln wird ein Reinstwasser-Overflow von beispielsweise mindestens 0,1 l/h/cm² erforderlich (0,1 Liter Reinstwasser pro Stunde pro cm² Flüssigkeitsoberfläche im Becken). Aus Gründen einer ausreichenden IPA-Konzentration an der Grenzfläche darf der Overflow diesen Wert auch nur geringfügig überschreiten. Zugleich muss der IPA/N₂-Strom im Vergleich zum GaAs entsprechend um 0,003 bis 0,007 l/h/cm² erhöht werden, um den stärkeren IPA-Austrag durch den Overflow zu kompensieren - damit die IPA-Konzentration an der Grenzfläche stabil bleibt.
- Neben den technischen und chemischen Einflussgrößen der Marangoni-Trocknung selbst hat auch die Behandlung der III-V-Halbleiterwafer in den der Trocknung vorgelagerten Prozessbecken einen Einfluss auf die Qualität der Marangoni-Trocknung und die Stärke der auftretenden Resttropfen an der Kontaktstelle mit zum Ausheben verwendeten Keil.
   Je nach Reinigungssequenz kann der letzte Reinigungsschritt aus einer sauren, basischen oder neutralen Lösung (z.B. durch ein nichtionisches Tensid) bestehen. Der pH-Wert des letzten chemischen Reinigungsschritts vor der Marangoni-Trocknung bestimmt die Oberflächenspannung der Waferoberfläche im Trocknungsprozess. Zur Optimierung der Trocknung kann die IPA-Konzentration an die Oberflächenspannung der zu trocknenden Wafer angepasst werden. So benötigen hydrophobe Wafer weniger Isopropanol als hydrophile Wafer (zum Beispiel hydrophob: < 0,01 l/h/cm² IPA/N₂, hydrophil: z.B. > 0,01 l/h/cm² IPA/N₂).
   Eine Steuerung der Oberflächenspannung der zu trocknenden Wafer kann beispielsweise zudem durch die Zugabe geringer Mengen an sauren oder basischen Additiven erreicht werden.

Ein erfindungsgemäßer Wafer weist an mindestens einer Oberfläche eine Oxidschicht auf. Diese Oberfläche weist in der Oxidschicht eine Defektfläche von unter 25 mm² auf. Der Wafer ist halbisolierend oder halbleitend. Die Oberfläche mit Oxidschicht wird auch als Oxidoberfläche bezeichnet.

Bei halbisolierenden Wafern sind sogar noch geringere Defektflächen möglich: Hier ist die Defektfläche vorzugsweise unter 15 mm², weiter vorzugsweise unter 10 mm², noch weiter vorzugsweise unter 5 mm². So ein Wafer besteht noch weiter vorzugsweise aus GaAs oder InP, noch weiter vorzugsweise aus undotiertem oder kohlenstoffdotiertem GaAs oder aus eisendotiertem InP.

Halbleitende Wafer können GaAs-Wafer sein und Silizium als Dotierstoff enthalten, oder ein InP-Wafer sein und Schwefel als Dotierstoff enthalten.

Vorzugsweise ist die Defektfläche ein zusammenhängender Bereich, wie beispielsweise in der Fig. 12 gezeigt. Dabei kann zumindest ein Teil der Defektfläche den Rand des Wafers kontaktieren.

Vorzugsweise ist mindestens ein Teil der Defektfläche max. 5 mm vom Rand des Wafers entfernt.

Weiter vorzugsweise befindet sich mindestens ein Teil der Defektfläche in einem Kreisring zwischen dem Rand des Wafers und einer virtuellen kreisförmigen Linie, welche max. 10 mm vom Rand des Wafers entfernt ist.

Ferner vorzugsweise befindet sich die gesamte Defektfläche in einem Kreisring zwischen dem Rand des Wafers und einer virtuellen kreisförmigen Linie, welche max. 10,5 mm vom Rand des Wafers entfernt ist.

Weiter vorzugsweise befindet sich die gesamte Defektfläche in einem Kreisring zwischen dem Rand des Wafers und einer virtuellen kreisförmigen Linie, welche max. 10 mm vom Rand des Wafers entfernt ist.

Optional hat der Wafer an einem Teil des Randes einen gerade geschliffenen Abschnitt oder eine Kerbe, und die Defektfläche liegt dem gerade geschliffenen Abschnitt oder der Kerbe gegenüber.

Entsprechende Wafer können mit dem erfindungsgemäßen Verfahren hergestellt werden, da hier Tropfen beim Trocknen minimiert werden können, was sich in einer besonders niedrigen Defektfläche niederschlägt.

Eine erfindungsgemäße Vorrichtung zum Trocknen von Wafern umfasst:
ein Bad 1 mit Flüssigkeit;
einen Keil 2,
mindestens eine Lagervorrichtung 5, welche vertikal verfahrbar ist;
wobei mindestens eine Horde 3, 31, 32 in die Lagervorrichtung 5 einsetzbar ist,
wobei die mindestens eine Horde 3, 31, 32 umfasst:
   ein Paar von ersten seitlichen Führungsvorrichtungen 3a, 3a', ein Paar von zweiten seitlichen Führungsvorrichtungen 3b, 3b' sowie ein Paar von dritten seitlichen Führungsvorrichtungen 3c, 3c',
   wobei das Paar von ersten seitlichen Führungsvorrichtungen 3a, 3a' unterhalb des Paars von zweiten seitlichen Führungsvorrichtungen 3b, 3b' angeordnet ist, und das Paar von zweiten seitlichen Führungsvorrichtungen 3b, 3b' unterhalb des Paars von dritten seitlichen Führungsvorrichtungen 3c, 3c' angeordnet ist, und
   wobei der Abstand des Paars von ersten seitlichen Führungsvorrichtungen 3a, 3a' voneinander kleiner ist als der Abstand des Paars von zweiten seitlichen Führungsvorrichtungen 3b, 3b' voneinander, und der der Abstand des Paars von zweiten seitlichen Führungsvorrichtungen 3b, 3b' voneinander kleiner ist als der Abstand des Paars von dritten seitlichen Führungsvorrichtungen 3c, 3c' voneinander, wobei der Keil 2 unterhalb der Horde 3 vorgesehen ist und vertikal getrennt von der Lagervorrichtung 5 verfahrbar ist,
   wobei der Keil 2 mindestens zwei Keilabschnitte 2a, 2b umfasst, wobei beide Keilabschnitte 2a, 2b getrennt voneinander vertikal verfahrbar sind,
   wobei in die Lagervorrichtung 5 mindestens eine erste Horde 31 so einsetzbar ist, dass die Mitte der mindestens ersten Horde 31 oberhalb der Spitze des ersten Keilabschnitts 2a positioniert ist, und ferner eine zweite Horde 32 so einsetzbar ist, dass die Mitte der zweiten Horde 32 oberhalb der Spitze des zweiten Keilabschnitts 2b positioniert ist.

Die im Vergleich zum Stand der Technik zwei zusätzlich seitlichen Führungsvorrichtungen (dritten seitlichen Führungsvorrichtungen 3c, 3c') führen dazu, dass diese den Wafer W, W1, W2 bereits zu dem Zeitpunkt seitlich halten können, wenn sich diese über die Flüssigkeitsoberfläche erhoben haben, und so kann, wenn der Wafer W, W1, W2 die Flüssigkeitsoberfläche passiert hat, ein Halten durch die dritten seitlichen Führungsvorrichtungen 3c, 3c' (oberhalb der Flüssigkeitsoberfläche) sowie den Keil 2, 2a, 2b (unterhalb der Flüssigkeitsoberfläche) erfolgen. Die ersten seitlichen Führungsvorrichtungen 3a, 3a' und die zweiten seitlichen Führungsvorrichtungen 3b, 3b' berühren den Wafer W, W1, W2 unter der Flüssigkeitsoberfläche nicht und berühren diesen auch während des Durchtritts durch die Flüssigkeitsoberfläche nicht, weswegen eine Gefahr der Tropfenbildung in diesen Bereichen unterbunden wird.

**In** der erfindungsgemäßen Vorrichtung wird daher für kleinere Wafer (z.B. Durchmesser von 150 mm oder kleiner) und größere (z.B. Durchmesser von 200 mm oder größer) Wafer jeweils ein eigener Keilabschnitt (2a für kleinere Wafer W1, 2b für größere Wafer W2) verwendet, mit einer entsprechend geeigneten Länge und jeweils angepassten Abständen von den Erhebungen 2c. Da die 200 mm-Wafer einen größeren Durchmesser haben, muss der Abstand der Erhebungen 2c größer als bei kleineren Waferdurchmessern sein, damit Wafer W2, wenn sie leicht kippen, sich gegenseitig nicht berühren.

So eine Vorrichtung ist zum Trocknen von Wafern mehrerer Durchmesser geeignet, ohne erhöhten konstruktiven Aufwand.

### Beispiele

GaAs-Wafer wurden mithilfe eines nasschemischen Reinigungsverfahrens gereinigt - Alle Wafer wurden doppelseitig vorpoliert und einseitig endpoliert.

Die Vorreinigung erfolgte unter Verwendung von NH₃ und HCl.

Die Endreinigung erfolgte mit dem Verfahren gemäß dem WO 2014/124980 A2: Die Wafer wurden einer basischen Reinigung unterzogen (verdünnte NH₃-Lösung plus Megaschall), mit deionisiertem Wasser gespült und anschließend mit Hilfe der Marangoni-Trocknung getrocknet.

### Beispiel 1:

Es wurden halbisolierende, undotierte GaAs-Wafer mit einem Durchmesser von 150 mm in einem Bad gereinigt und anschließend mit Hilfe der Marangoni-Trockung getrocknet. Die undotierten Wafer wurden aus Kristallen hergestellt, die mit dem VGF-Verfahren gezüchtet wurden und hatten einen spezifischen Widerstand zwischen 1x10⁸ und 8x10⁸ Ωcm.

48 GaAs-Wafer wurden mit einem erfindungsgemäßen Verfahren gemäß Fig. 3 getrocknet. Die Verfahrgeschwindigkeit der Wafer betrug größtenteils 1 mm/s (für einzelne Phasen des Aushebens sind Änderungen möglich, siehe oben sowie Anspruch 8). Mit Verfahrgeschwindigkeit ist die Geschwindigkeit der Wafer gegenüber der Wasseroberfläche gemeint.

### Vergleichsbeispiel 1:

Es wurden halbisolierende, undotierte GaAs-Wafer mit einem Durchmesser von 150 mm in einem Bad gereinigt und anschließend mit Hilfe der Marangoni-Trockung getrocknet. Die undotierten Wafer wurden aus Kristallen hergestellt, die mit dem VGF-Verfahren gezüchtet wurden und hatten einem spezifischen Widerstand zwischen 1x10⁸ und 8x10⁸ Ωcm.

46 GaAs-Wafer wurden mit einem Verfahren gemäß Fig. 1 (Stand der Technik) getrocknet. Die Verfahrgeschwindigkeit der Wafer betrug größtenteils 1 mm/s (für einzelne Phasen des Aushebens sind Änderungen möglich, siehe oben sowie Anspruch 8).

Der Vergleich des Beispiels 1 und Vergleichsbeispiels 1 ist in Fig. 14 dargestellt.

### Beispiel 2:

Es wurden Silizium-dotierte GaAs-Wafer (halbleitend) mit einem Durchmesser von 150 mm in einem Bad gereinigt und anschließend mit Hilfe der Marangoni-Trockung getrocknet. Die dotierten Wafer wurden aus Kristallen hergestellt, die mit dem VGF-Verfahren gezüchtet wurden und hatten eine Si-Dotierung mit einer Ladungsträgerkonzentration zwischen 1x10¹⁸ und 3x10¹⁸ cm⁻³.

84 Silizium-dotierte GaAs-Wafer wurden mit einem erfindungsgemäßen Verfahren gemäß Fig. 3 getrocknet. Die Verfahrgeschwindigkeit der Wafer betrug größtenteils 1 mm/s (für einzelne Phasen des Aushebens sind Änderungen möglich, siehe oben sowie Anspruch 8).

### Vergleichsbeispiel 2:

Es wurden Si-dotierte GaAs-Wafer (halbleitend) mit einem Durchmesser von 150 mm in einem Bad gereinigt und anschließend mit Hilfe der Marangoni-Trockung getrocknet.

88 Silizium-dotierte GaAs-Wafer wurden mit einem Verfahren gemäß Fig. 1 (Stand der Technik) getrocknet. Die Verfahrgeschwindigkeit der Wafer betrug größtenteils 1 mm/s (für einzelne Phasen des Aushebens sind Änderungen möglich, siehe oben sowie Anspruch 8).

Der Vergleich des Beispiels 2 und Vergleichsbeispiels 2 ist in Fig. 15 dargestellt.

### Beispiel 3:

Es wurden S-dotierte, halbleitende InP-Wafer mit einem Durchmesser von 100 mm in einem Bad gereinigt und anschließend mit Hilfe der Marangoni-Trockung getrocknet. Die mit Schwefel dotierten Wafer wurden aus Kristallen hergestellt, die mit dem VGF-Verfahren gezüchtet wurden und hatten eine Schwefel-Dotierung mit einer Ladungsträgerkonzentration zwischen 1,5x10¹⁸ und 9x10¹⁸ cm⁻³.

19 InP-Wafer wurden mit einem erfindungsgemäßen Verfahren gemäß Fig. 3 getrocknet. Die Verfahrgeschwindigkeit der Wafer betrug größtenteils 1 mm/s (für einzelne Phasen des Aushebens sind Änderungen möglich, siehe oben sowie Anspruch 8).

### Vergleichsbeispiel 3:

Es wurden S-dotierte, halbleitende InP-Wafer mit einem Durchmesser von 100 mm in einem Bad gereinigt und anschließend mit Hilfe der Marangoni-Trockung getrocknet. Die mit Schwefel dotierten Wafer wurden aus Kristallen hergestellt, die mit dem VGF-Verfahren gezüchtet wurden und hatten eine S-Dotierung mit einer Ladungsträgerkonzentration zwischen 1,5x10¹⁸ und 9x10¹⁸ cm⁻³.

29 InP-Wafer wurden mit einem Verfahren gemäß Fig. 1 (Stand der Technik) getrocknet. Die Verfahrgeschwindigkeit der Wafer betrug größtenteils 1 mm/s (für einzelne Phasen des Aushebens sind Änderungen möglich, siehe oben sowie Anspruch 8).

Der Vergleich des Beispiels 3 und Vergleichsbeispiels 3 ist in Fig. 16 dargestellt.

### Beispiel 4:

Es wurden Fe-dotierte, halbisolierende InP-Wafer mit einem Durchmesser von 150 mm in einem Bad gereinigt und anschließend mit Hilfe der Marangoni-Trockung getrocknet. Die mit Fe dotierten Wafer wurden aus Kristallen hergestellt, die mit dem VGF-Verfahren gezüchtet wurden und hatten eine Eisen-Dotierung mit einer Ladungsträgerkonzentration zwischen 2,8x10⁷ und 3,8x10⁷ cm⁻³. Der spezifische Widerstand betrug 4,9 x10⁷ bis 8,7 x10⁷ Ω*cm. Die Versetzungsdichte betrug 290 bis 480 cm⁻².

23 InP-Wafer wurden mit einem erfindungsgemäßen Verfahren gemäß Fig. 3 getrocknet. Die Verfahrgeschwindigkeit der Wafer betrug größtenteils 1 mm/s (für einzelne Phasen des Aushebens sind Änderungen möglich, siehe oben sowie Anspruch 8).

### Vergleichsbeispiel 4:

Es wurden Fe-dotierte, halbisolierende InP-Wafer mit einem Durchmesser von 150 mm in einem Bad gereinigt und anschließend mit Hilfe der Marangoni-Trockung getrocknet. Die mit Fe dotierten Wafer wurden aus Kristallen hergestellt, die mit dem VGF-Verfahren gezüchtet wurden und hatten eine Eisen-Dotierung mit einer Ladungsträgerkonzentration zwischen 2,8x10⁷ und 3,8x10⁷ cm⁻³. Der spezifische Widerstand betrug 4,9 x10⁷ bis 8,7 x10⁷ Ω*cm. Die Versetzungsdichte betrug 290 bis 480 cm⁻².

12 InP-Wafer wurden mit einem Verfahren gemäß Fig. 1 (Stand der Technik) getrocknet. Die Verfahrgeschwindigkeit der Wafer betrug größtenteils 1 mm/s (für einzelne Phasen des Aushebens sind Änderungen möglich, siehe oben sowie Anspruch 8).

Der Vergleich des Beispiels 4 und Vergleichsbeispiels 4 ist in Fig. 19 dargestellt.

### Oberflächencharakterisierung der Wafer:

Die Oberflächeneigenschaften des Wafers (die Beschaffenheit der Oxidoberfläche auf dem Wafer) werden nach der Trocknung mit einem optischen Oberflächenanalysator (Candela-Ellipsometer) charakterisiert. Zur Charakterisierung der Homogenität der Oberflächeneigenschaften wird ein Mapping des Messkanals QAbsPhase des Candela CS20 der Firma KLA ausgewertet. Die radiale Auflösung der Candela-Messung beträgt 50 µm, die azimutale Auflösung < 30 µm.

Die Mappings zeigen helle und dunkle Bereiche sowie Streifenstrukturen, die Inhomogenitäten bzw. allgemein "Defekten" zugeordnet werden können. Die Intensität und die Anzahl der Abweichungen vom Hintergrund charakterisieren die Homogenität einer Oberfläche.

Bei der Bestimmung der Tropfengrößen werden die Kontraste nicht durch Schwellwerte, sondern durch ihre Ausprägung visuell bzw. durch einen angelernten Algorithmus bzw. ein neuronales Netzwerk ausgewertet (siehe oben); hier wird nicht der Absolutbetrag des Messignals betrachtet, sondern nur klar erkennbare Tropfenbereiche, und diese Auswertung erfolgt außerhalb des Candela-Ellipsometers.

Es erfolgt ein Randausschluss von max. 0,5 mm. Die Ausdehnung der gefundenen Tropfen nach innen beträgt maximal ca. 1 cm, so dass der Bereich, der betrachtet wird, für einen 150-mm-Wafer einen Radiusbereich zwischen 65 mm und 74,5 mm abdeckt, und für einen 100-mm-Wafer einen Radiusbereich zwischen 40 mm und 49,5 mm.

Die folgenden Punkte gehören ebenfalls zur Offenbarung der vorliegenden Erfindung:
1. Verfahren zum Trocknen eines Wafers (W), welcher sich in einem Bad (1) befindet, mithilfe einer Anordnung, welche mindestens einen Keil (2) sowie
   ein Paar von ersten seitlichen Führungsvorrichtungen (3a, 3a'), ein Paar von zweiten seitlichen Führungsvorrichtungen (3b, 3b') sowie ein Paar von dritten seitlichen Führungsvorrichtungen (3c, 3c') aufweist,
   wobei das Paar von ersten seitlichen Führungsvorrichtungen (3a, 3a') unterhalb des Paars von zweiten seitlichen Führungsvorrichtungen (3b, 3b') angeordnet ist, und das Paar von zweiten seitlichen Führungsvorrichtungen (3b, 3b') unterhalb des Paars von dritten seitlichen Führungsvorrichtungen (3c, 3c') angeordnet ist, und
   wobei das Verfahren die folgenden Schritte aufweist:
      i) Vertikales Bewegen des mindestens einen Keils (2) nach oben, bis dieser den Wafer an dessen unterstem Punkt berührt, vertikales Bewegen des Paars von ersten seitlichen Führungsvorrichtungen (3a, 3a') und des Paars von zweiten seitlichen Führungsvorrichtungen (3b, 3b') nach oben, wobei der Wafer (W) das Paar von ersten seitlichen Führungsvorrichtungen (3a) und das Paar von zweiten seitlichen Führungsvorrichtungen (3b) berührt, wobei ein oberer Bereich des Wafers (W) aus dem Bad (1) hinausgeschoben wird, wobei das Paar von dritten seitlichen Führungsvorrichtung (3c) den Wafer nicht berührt;
      ii) Vertikales Bewegen des Keils (2) nach oben, bis das Paar von ersten seitlichen Führungsvorrichtungen (3a, 3a') sowie das Paar von zweiten seitlichen Führungsvorrichtungen (3b, 3b') den Wafer (W) nicht mehr berühren, während sie sich noch unter der Flüssigkeitsoberfläche des Bades (1) befinden, wobei das Paar von dritten seitlichen Führungsvorrichtungen (3c, 3c') den Wafer oberhalb der Flüssigkeitsoberfläche des Bades (1) berührt;
      iii) Herausschieben des Wafers (W) oberhalb den Flüssigkeitsspiegels des Bads (1), wobei das Paar von dritten seitlichen Führungsvorrichtungen (3c, 3c') den Wafer (W) berührt.
2. Verfahren zum Trocknen eines Wafers (W) gemäß Punkt 1, ferner die folgenden Schritte umfassend:
   iv) Vertikales Bewegen eines Keils (2) nach unten, bis der Wafer (W) mindestens eine des Paars von ersten seitlichen Führungsvorrichtungen (3a) und des Paars von zweiten seitlichen Führungsvorrichtungen (3b) berührt;
   v) Weiteres vertikales Bewegen eines Keils (2) nach unten, bis dieser den Wafer (W) nicht mehr berührt;
   wobei parallel zu den Schritten iv) und/oder v) oder nach dem Schritt v) der Flüssigkeitsspiegels des Bads (1) abgesenkt wird, bis der Flüssigkeitsspiegel sich unterhalb des Keils (2) befindet.
3. Verfahren gemäß Punkt 1 oder 2, wobei das Bad Wasser (1) sowie mindestens eine weitere oberflächenspannungsreduzierende Substanz, vorzugsweise Isopropanol, enthält.
4. Verfahren gemäß einem der vorhergehenden Punkte, wobei das Paar von ersten seitlichen Führungsvorrichtungen (3a, 3a'), das Paar von zweiten seitlichen Führungsvorrichtungen (3b, 3b') und/oder das Paar von dritten seitlichen Führungsvorrichtungen (3c, 3c') jeweils aus einem Paar Stege besteht, welche dazu angepasst sind, gegenüberliegende Seiten des Wafers (W, W1, W2) zu berühren.
5. Verfahren gemäß einem der vorhergehenden Punkte 2 bis 4, wobei in Schritt i) das Paar von ersten seitlichen Führungsvorrichtungen (3a, 3a') sowie das Paar von zweiten seitlichen Führungsvorrichtungen (3b, 3b') im Bad (1) eingetaucht bleiben, und vorzugsweise am Ende des Schritts v) das Paar von dritten seitlichen Führungsvorrichtungen (3c, 3c') den Wafer (W, W1, W2) nicht berührt.
6. Verfahren gemäß einem der vorhergehenden Punkte, wobei der Keil (2, 2a, 2b) mit Absaugvorrichtungen (6) versehen ist, an welche ein Unterdruck anlegbar ist, wenn sich die obere Spitze des Keils (2, 2a, 2b) oberhalb des Flüssigkeitsspiegels befindet.
7. Verfahren gemäß einem der vorhergehenden Punkte, wobei der Keil (2, 2a, 2b) eine oberflächenspannungserhöhende Oberflächenstruktur aufweist.
8. Verfahren gemäß einem der Punkte 1 bis 7, wobei die
   Aushebegeschwindigkeit abhängig von der Position des untersten Punkts des Wafers (W) ist,
   und zwischen 0,8 und 1,2 mm/s beträgt, wenn der unterste Punkt des Wafers (W) mehr als 1,2 cm unter dem Flüssigkeitsspiegel liegt, zwischen 0,4 und 0,5 mm/s beträgt, wenn der unterste Punkt des Wafers (W) weniger als 1,2 cm unter dem Flüssigkeitsspiegel liegt, und mindestens 30 mm/s, vorzugsweise mindestens 40 mm/s, weiter vorzugsweise mindestens 50 mm/s beträgt, sobald der unterste Punkt des Wafers (W) den Flüssigkeitsspiegel erreicht hat.
9. Verfahren gemäß einem der Punkte 1 bis 8, wobei das Paar von ersten seitlichen Führungsvorrichtungen (3a, 3a'), das Paar von zweiten seitlichen Führungsvorrichtungen (3b, 3b') sowie das Paar von dritten seitlichen Führungsvorrichtungen (3c, 3c') an einer Horde (3) vorgesehen ist, und in Schritt i) die Horde (3) bewegt wird, in Schritt iii) der Wafer (W) oberhalb den Flüssigkeitsspiegels des Bads (1) herausgeschoben wird, wobei das Paar von dritten seitlichen Führungsvorrichtungen (3c, 3c') und der Keil (2) den Wafer (W) berühren.
10. Verfahren gemäß einem der Punkte 1 bis 8, wobei das Paar von dritten seitlichen Führungsvorrichtungen (3c, 3c') in allen Verfahrensschritten oberhalb des Flüssigkeitsspiegels positioniert ist und unabhängig von dem Paar von ersten seitlichen Führungsvorrichtungen (3a, 3a') und dem Paar von zweiten seitlichen Führungsvorrichtungen (3b, 3b') beweglich ist, und die dritten seitlichen Führungsvorrichtungen (3c, 3c') relativ zueinander horizontal beweglich sind.
11. Verfahren gemäß Punkt 10, wobei der Keil (2) in allen Verfahrensschritten unterhalb des Flüssigkeitsspiegels bleibt.
12. Verfahren gemäß einem der Punkte 10 oder 11, wobei in Schritt iii) der Abstand der Punkte, an denen die dritten seitlichen Führungsvorrichtungen (3c, 3c') den Wafer berühren, stetig verringert wird.
13. Verfahren gemäß einem der Punkte 10 bis 12, wobei die dritten seitlichen Führungsvorrichtungen (3c, 3c') entweder azentrisch gelagert sind oder eine ovale Form aufweisen und dazu angepasst sind, eine Drehbewegung auszuführen.
14. III-V-Wafer (W, W1, W2), wobei mindestens eine Oberfläche das Wafers eine Oxidschicht aufweist, wobei diese Oberfläche eine Defektfläche von unter 25 mm² aufweist, und wobei der III-V-Wafer (W) halbisolierend oder halbleitend ist.
15. III-V-Wafer (W, W1, W2) gemäß Punkt 14, wobei die Oxidoberfläche eine Defektfläche von unter 15 mm², vorzugsweise unter 10 mm², weiter vorzugsweise unter 5 mm² aufweist, wobei der III-V-Wafer (W, W1, W2) halbisolierend ist und vorzugsweise aus GaAs oder **InP** besteht, weiter vorzugsweise aus undotiertem oder kohlenstoffdotiertem GaAs oder aus eisendotiertem InP.
16. III-V-Wafer (W, W1, W2) gemäß Punkt 14, wobei der III-V-Wafer halbleitend ist und wobei der Wafer ein GaAs-Wafer ist und Silizium als Dotierstoff enthält oder wobei der III-V-Wafer ein InP-Wafer ist und Schwefel als Dotierstoff enthält.

### BEZUGSZEICHENLISTE

- 1: Bad
- 2, 2a, 2b: Keil
- 2c: Erhebung
- 3: Horde
- 31: erste Horde
- 32: zweite Horde
- 3a, 3a': erste seitlichen Führungsvorrichtung
- 3b, 3b': zweite seitliche Führungsvorrichtung
- 3c, 3c': dritte seitliche Führungsvorrichtung
- 3d, 3d': Kopfteil
- 4: Greifvorrichtung
- 5: Lagervorrichtung
- 6: Absaugvorrichtung

- W: Wafer
- H, H': Haltevorrichtung

## Patentansprüche

1. Vorrichtung zum Trocknen von Wafern, umfassend:
ein Bad (1) mit Flüssigkeit;
einen Keil (2),
mindestens eine Lagervorrichtung (5), welche vertikal verfahrbar ist;
wobei mindestens eine Horde (3; 31, 32) in die Lagervorrichtung (5) einsetzbar ist,
wobei die mindestens eine Horde (3; 31, 32) umfasst:
ein Paar von ersten seitlichen Führungsvorrichtungen (3a, 3a'), ein Paar von zweiten seitlichen Führungsvorrichtungen (3b, 3b') sowie ein Paar von dritten seitlichen Führungsvorrichtungen (3c, 3c'),
wobei das Paar von ersten seitlichen Führungsvorrichtungen (3a, 3a') unterhalb des Paars von zweiten seitlichen Führungsvorrichtungen (3b, 3b') angeordnet ist, und das Paar von zweiten seitlichen Führungsvorrichtungen (3b, 3b') unterhalb des Paars von dritten seitlichen Führungsvorrichtungen (3c, 3c') angeordnet ist, und
wobei der Abstand des Paars von ersten seitlichen Führungsvorrichtungen (3a, 3a') voneinander kleiner ist als der Abstand des Paars von zweiten seitlichen Führungsvorrichtungen (3b, 3b') voneinander, und der Abstand des Paars von zweiten seitlichen Führungsvorrichtungen (3b, 3b') voneinander kleiner ist als der Abstand des Paars von dritten seitlichen Führungsvorrichtungen (3c, 3c') voneinander,
wobei der Keil (2) unterhalb der Horde (3) vorgesehen ist und vertikal getrennt von der Lagervorrichtung (5) verfahrbar ist, wobei der Keil (2) mindestens zwei Keilabschnitte (2a, 2b) umfasst, wobei beide Keilabschnitte (2a,2b) getrennt voneinander vertikal verfahrbar sind, wobei in die Lagervorrichtung (5) mindestens eine erste Horde (31) so einsetzbar ist, dass die Mitte der mindestens ersten Horde (31) oberhalb der Spitze des ersten Keilabschnitts (2a) positioniert ist, und ferner eine zweite Horde (32) so einsetzbar ist, dass die Mitte der zweiten Horde (32) oberhalb der Spitze des zweiten Keilabschnitts (2b) positioniert ist.

2. Vorrichtung gemäß Anspruch 1, wobei der Keil (2) unabhängig von der Lagervorrichtung (5) bzw. Horde (3) vertikal verfahrbar ist.

3. Vorrichtung gemäß Anspruch 1 oder 2, wobei die erste Horde (31) dazu angepasst ist, einen Wafer (W1) mit einem ersten Durchmesser zu halten, und die zweite Horde (32) dazu angepasst ist, einen Wafer (W2) mit einem zweiten Durchmesser zu halten, wobei der erste Durchmesser kleiner ist als der zweite Durchmesser.

4. Vorrichtung gemäß einem der Ansprüche 1 bis 3, wobei die Spitze des ersten Keilabschnitts (2a) und/oder zweiten Keilabschnitts (2b) als Dreieck, vorzugsweise rechtwinkliges Dreieck ausgebildet ist.

5. Vorrichtung gemäß einem der Ansprüche 1 bis 4, während der erste Keilabschnitt (2a) zweigeteilt ist, und zwei Bereiche vorhanden sind, in welchen der erste Keilabschnitt (2a) und der zweite Keilabschnitt (2b) nebeneinander angeordnet sind.
